(19) Europäisches Patentamt / European Patent Office / Office européen des brevets

(11) **EP 4 741 341 A1**

(12) **EUROPEAN PATENT APPLICATION**
published in accordance with Art. 153(4) EPC

(43) Date of publication:
**13.05.2026 Bulletin 2026/20**

(21) Application number: **24839401.7**

(22) Date of filing: **13.06.2024**

(51) International Patent Classification (IPC):
$C01B\ 32/158^{(2017.01)}$    $B01J\ 27/043^{(2006.01)}$
$C01B\ 32/174^{(2017.01)}$    $H01B\ 1/04^{(2006.01)}$
$H01M\ 4/13^{(2010.01)}$    $H01M\ 4/62^{(2006.01)}$

(52) Cooperative Patent Classification (CPC):
Y02E 60/10

(86) International application number:
**PCT/JP2024/021496**

(87) International publication number:
**WO 2025/013505 (16.01.2025 Gazette 2025/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.07.2023 JP 2023112658**
**29.03.2024 JP 2024057342**

(71) Applicant: **Sumitomo Chemical Company, Limited Tokyo 103-6020 (JP)**

(72) Inventors:
• **ARIMURA, Takashi**
**Tsukuba-shi, Ibaraki 300-3294 (JP)**
• **BANDO, Akinori**
**Ichihara-shi, Chiba 299-0195 (JP)**
• **AKATSU, Mitsutoshi**
**Tsukuba-shi, Ibaraki 300-3294 (JP)**
• **YASHIRO, Arihiro**
**Tsukuba-shi, Ibaraki 300-3294 (JP)**

(74) Representative: **J A Kemp LLP**
**80 Turnmill Street**
**London EC1M 5QU (GB)**

(54) **MULTILAYER CARBON NANOTUBE ASSEMBLY, MULTILAYER CARBON NANOTUBE DISPERSION LIQUID, CONDUCTIVE MATERIAL, ELECTRODE, SECONDARY BATTERY, PLANAR ASSEMBLY, FILTER, ELECTROMAGNETIC WAVE SHIELD, AND PELLICLE FOR EXTREME ULTRAVIOLET RAYS**

(57)    There are provided a multi-walled carbon nanotube assembly having high conductivity, a multi-walled carbon nanotube dispersion liquid, a conductive material, an electrode, a secondary battery, a planar assembly, a filter, an electromagnetic wave shielding, and a pellicle for extreme ultraviolet rays.

A multi-walled carbon nanotube assembly, a multi-walled carbon nanotube dispersion liquid, a conductive material, an electrode, a secondary battery, a planar assembly, a filter, an electromagnetic wave shielding, and a pellicle for extreme ultraviolet rays, each including multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass.

Fig. 1A

S4800 1.0kV x500 SE(M)    100um

Fig. 1B

S4800 1.0kV x500 SE(M)      100um

Fig. 1C

S4800 1.0kV x500 SE(U)      100um

## Description

Technical Field

The present disclosure relates to a multi-walled carbon nanotube assembly, a multi-walled carbon nanotube dispersion liquid, a conductive material, an electrode, a secondary battery, a planar assembly, a filter, an electromagnetic wave shielding, and a pellicle for extreme ultraviolet rays.

Background Art

Carbon nanotubes (also referred to as "CNTs") are substances having a cylindrical structure formed by rolling graphene sheets, in which carbon atoms are arranged in a hexagonal honeycomb pattern, into a tubular shape. Due to their excellent characteristics such as conductivity, thermal conductivity, and heat resistance, CNTs are expected to be applied to various electronic materials, including electrode materials for energy storage devices.

Basically, CNTs are broadly classified into single-walled carbon nanotubes (also referred to as "SWCNTs") formed from a single layer of graphene sheet, and multi-walled carbon nanotubes (also referred to as "MWCNTs") formed from multiple layers of graphene sheets. MWCNTs have the advantage of superior thermal stability and chemical stability compared to SWCNTs, and in recent years, attempts have been made to enhance the characteristics of MWCNTs more effectively.

For example, Patent Literature 1 discloses CNTs having two or more layers of coaxial tubes of graphene sheets in which carbon atoms are arranged in a hexagonal honeycomb pattern, wherein, in the MWCNTs, the diameter of the outermost layer based on image observation with a transmission electron microscope is 3 nm or more and 15 nm or less, and the length based on image observation with a scanning electron microscope is 1.0 mm or more. According to the MWCNTs disclosed in Patent Literature 1, the applicability to materials requiring high conductivity, high thermal conductivity, and the like is considered to be enhanced.

Citation List

Patent Literature

Patent Literature 1: Japanese Patent Laid-Open No. 2020-180028

Summary of Invention

Problems to be Solved by Invention

In recent years, interest in the usefulness of MWCNTs as electronic materials has been increasing. For example, when MWCNTs are used as electrode materials such as conductive auxiliary agents, high conductivity can be imparted to the electrodes, and thus an improvement in the performance of energy storage devices can be expected.

However, conventional MWCNTs, including the MWCNTs disclosed in Patent Literature 1, still have room for improvement in terms of the effect of enhancing conductivity when used in electrodes as electrode materials.

The present disclosure has been made in view of the above circumstances.

A problem to be solved by one embodiment of the present disclosure is to provide a multi-walled carbon nanotube assembly having high conductivity.

Problems to be solved by other embodiments of the present disclosure are to provide a multi-walled carbon nanotube dispersion liquid, a conductive material, an electrode, a secondary battery, and a planar assembly, each comprising the multi-walled carbon nanotube assembly described above.

In addition, problems to be solved by other embodiments of the present disclosure are to provide a filter, an electromagnetic wave shielding, and a pellicle for extreme ultraviolet rays, each comprising the planar assembly described above.

Means to Solve the Problems

Specific means for solving the above problems include the following aspects.

[1] A multi-walled carbon nanotube assembly comprising multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass.

[2] A multi-walled carbon nanotube assembly comprising multi-walled carbon nanotubes having a scattering intensity ratio S1/S2 of 90 or more, which is a ratio of a scattering intensity S1 at a scattering vector magnitude $q = 0.2$ nm$^{-1}$ to a scattering intensity S2 at a scattering vector magnitude $q = 0.8$ nm$^{-1}$ in a scattering profile obtained by a small-angle X-ray scattering method when formed into an aqueous dispersion liquid having a concentration of 0.2% by mass.

[3] A multi-walled carbon nanotube assembly comprising multi-walled carbon nanotubes having a scattering intensity ratio S3/S4 of 10 or less, which is a ratio of a scattering intensity S3 at a scattering vector magnitude $q = 0.02$ nm$^{-1}$ to a scattering intensity S4 at a scattering vector magnitude $q = 0.08$ nm$^{-1}$ in a scattering profile obtained by a small-angle X-ray scattering method when formed into an aqueous dispersion liquid having a concentration of 0.2% by mass.

[4] A multi-walled carbon nanotube assembly comprising multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass, and having a scattering intensity ratio S1/S2 of 90 or more, which is a ratio of a scattering intensity S1 at a scattering vector magnitude $q = 0.2$ nm$^{-1}$ to a scattering intensity S2 at a scattering vector magnitude $q = 0.8$ nm$^{-1}$ in a scattering profile obtained by a small-angle X-ray scattering method when formed into an aqueous dispersion liquid having a concentration of 0.2% by mass.

[5] A multi-walled carbon nanotube assembly comprising multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass, and having a scattering intensity ratio S3/S4 of 10 or less, which is a ratio of a scattering intensity S3 at a scattering vector magnitude $q = 0.02$ nm$^{-1}$ to a scattering intensity S4 at a scattering vector magnitude $q = 0.08$ nm$^{-1}$ in a scattering profile obtained by a small-angle X-ray scattering method when formed into an aqueous dispersion liquid having a concentration of 0.2% by mass.

[6] A multi-walled carbon nanotube assembly comprising multi-walled carbon nanotubes having a scattering intensity ratio S1/S2 of 90 or more, which is a ratio of a scattering intensity S1 at a scattering vector magnitude $q = 0.2$ nm$^{-1}$ to a scattering intensity S2 at a scattering vector magnitude $q = 0.8$ nm$^{-1}$ in a scattering profile obtained by a small-angle X-ray scattering method, and having a scattering intensity ratio S3/S4 of 10 or less, which is a ratio of a scattering intensity S3 at a scattering vector magnitude $q = 0.02$ nm$^{-1}$ to a scattering intensity S4 at a scattering vector magnitude $q = 0.08$ nm$^{-1}$ in the scattering profile, when formed into an aqueous dispersion liquid having a concentration of 0.2% by mass.

[7] The multi-walled carbon nanotube assembly according to any one of [1] to [6], wherein a maximum length of the multi-walled carbon nanotubes is 1000 $\mu$m to 30000 $\mu$m.

[8] The multi-walled carbon nanotube assembly according to any one of [1] to [7], which is a conductive auxiliary agent.

[9] A multi-walled carbon nanotube dispersion liquid comprising the multi-walled carbon nanotube assembly according to any one of [1] to [7], and a dispersion medium.

[10] A conductive material comprising the multi-walled carbon nanotube assembly according to any one of [1] to [7].

[11] An electrode comprising an electrode active material and the conductive material according to [10].

[12] A secondary battery comprising the electrode according to [11] .

[13] A composition comprising the multi-walled carbon nanotube assembly according to any one of [1] to [7], and at least one selected from the group consisting of resin, ceramic, and concrete.

[14] A planar assembly comprising the multi-walled carbon nanotube assembly according to any one of [1] to [7].

[15] A filter comprising the planar assembly according to [14].

[16] An electromagnetic wave shielding comprising the planar assembly according to [14].

[17] A pellicle for extreme ultraviolet rays comprising the planar assembly according to [14].

Effects of Invention

According to one embodiment of the present disclosure, there is provided a multi-walled carbon nanotube assembly having high conductivity.

According to other embodiments of the present disclosure, there are provided a multi-walled carbon nanotube dispersion liquid, an electrode, a secondary battery, a conductive material, and a planar assembly, each comprising the multi-walled carbon nanotube assembly described above.

In addition, according to other embodiments of the present disclosure, there are provided a filter, an electromagnetic wave shielding, and a pellicle for extreme ultraviolet rays, each comprising the planar assembly described above.

Brief Description of Drawings

[Figure 1A] Figure 1A is a scanning electron microscope (SEM) image of a dispersion liquid containing the MWCNT assembly of Example 1.
[Figure 1B] Figure 1B is a scanning electron microscope (SEM) image of a dispersion liquid containing the SWCNT assembly of Comparative Example 1.
[Figure 1C] Figure 1C is a scanning electron microscope (SEM) image of a dispersion liquid containing the MWCNT assembly of Comparative Example 2.
[Figure 2] Figure 2 is a graph of the scattering profiles of the MWCNT assembly of Example 1, the SWCNT assembly of Comparative Example 1, and the MWCNT assembly of Comparative Example 2, obtained by a small-angle X-ray scattering method.

Embodiments for Carrying out Invention

Hereinafter, the multi-walled carbon nanotube assembly, multi-walled carbon nanotube dispersion liquid, conductive material, electrode, secondary battery, planar assembly, filter, electromagnetic wave shielding, and pellicle for extreme ultraviolet rays according to the present disclosure will be described in detail. The following description of the requirements may be made based on representative embodiments of the present disclosure; however, the present disclosure is not limited to such embodiments, and can be carried out with appropriate modifications within the scope of the objectives of the present disclosure.

In the present disclosure, a numerical range indicated using "to" means a range including the numerical values described before and after "to" as the lower limit value and the upper limit value, respectively.

In the numerical ranges described stepwise in the present disclosure, the upper limit value or lower limit value described in one numerical range may be replaced with the upper limit value or lower limit value of another numerical range described stepwise. In addition, in the numerical ranges described in the present disclosure, the upper limit value or lower limit value described in one numerical range may be replaced with the values shown in the Examples.

In the present disclosure, combinations of two or more preferred aspects are more preferred aspects.

In the present disclosure, the term "step" includes not only independent steps but also steps that cannot be clearly distinguished from other steps, provided that the intended purpose of the step is achieved.

In the present disclosure, the term "fiber" is used to refer to a structure in which one dimension is larger than the other two dimensions. The fiber may be a thread-like fiber having a circular cross-section, a ribbon-like fiber having a rectangular cross-section, a hollow fiber, or a fiber having any other shape.

From the viewpoint of enhancing the conductivity of the assembly of the present disclosure, the cross-section of the MWCNTs is preferably circular, and more preferably hollow.

In the present disclosure, "carbon nanotubes" are also referred to as "CNTs", "single-walled carbon nanotubes" are also referred to as "SWCNTs", "multi-walled carbon nanotubes" are also referred to as "MWCNTs", "multi-walled carbon nanotube assembly" is also referred to as "MWCNT assembly", and "multi-walled carbon nanotube dispersion liquid" is also referred to as "MWCNT dispersion liquid".

[Multi-walled carbon nanotube assembly]

One embodiment of the multi-walled carbon nanotube assembly according to the present disclosure is a multi-walled carbon nanotube assembly comprising multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass.

In the present disclosure, the multi-walled carbon nanotube assembly according to this embodiment is also referred to as "MWCNT assembly (A)".

The MWCNT assembly (A) according to the present disclosure has high conductivity.

The reason why the MWCNT assembly (A) according to the present disclosure has high conductivity is not clear, but the present inventors speculate as follows. However, the following speculation is not intended to limit the MWCNT assembly (A) according to the present disclosure, and is described merely as an example.

The present inventors have obtained findings regarding the relationship between the median diameter in a volume-based particle size distribution obtained by a centrifugal sedimentation method when the MWCNTs are formed into an aqueous dispersion liquid having a specific concentration, and a structure formed by entanglement of MWCNTs with each other. In detail, it has been found that a larger median diameter suggests that the structure formed by entanglement of MWCNTs with each other is larger in size. The present inventors have also obtained findings regarding the relationship between the rate of change in transmittance as measured by a centrifugal sedimentation method when the MWCNTs are formed into an aqueous dispersion liquid having a specific concentration, and the stability in the aqueous dispersion liquid of a structure formed by entanglement of MWCNTs with each other. In detail, it has been found that a slower rate of change in transmittance suggests that the structure formed by entanglement of MWCNTs with each other can stably exist in the aqueous dispersion liquid.

The MWCNT assembly (A) according to the present disclosure is considered to form a network structure that is large in size and can stably exist in an aqueous dispersion liquid, in which the MWCNTs are entangled with each other. It is speculated that the formation of a network structure by the MWCNTs leads to multiple points of contact between the MWCNTs, resulting in the formation of a large conductive path, thereby increasing conductivity.

Another embodiment of the multi-walled carbon nanotube assembly according to the present disclosure is a multi-walled carbon nanotube assembly comprising multi-walled carbon nanotubes having a scattering intensity ratio $S1/S2$ of 90 or more, which is the ratio of the scattering intensity $S1$ at a scattering vector magnitude $q = 0.2$ $nm^{-1}$ to the scattering intensity $S2$ at a scattering vector magnitude $q = 0.8$ $nm^{-1}$ in a scattering profile obtained by a small-angle X-ray scattering (SAXS) method when formed into an aqueous dispersion liquid having a concentration of 0.2% by mass.

In the present disclosure, the multi-walled carbon nanotube assembly according to this embodiment is also referred to as "MWCNT assembly (B)".

The MWCNT assembly (B) according to the present disclosure has high conductivity.

The reason why the MWCNT assembly (B) according to the present disclosure has high conductivity is not clear, but the present inventors speculate as follows. However, the following speculation is not intended to limit the MWCNT assembly (B) according to the present disclosure, and is described merely as an example.

The present inventors have obtained findings regarding the relationship between the scattering intensity ratio $S1/S2$, which is the ratio of the scattering intensity $S1$ at a scattering vector magnitude $q = 0.2$ $nm^{-1}$ to the scattering intensity $S2$ at a scattering vector magnitude $q = 0.8$ $nm^{-1}$ in a scattering profile obtained by a small-angle X-ray scattering method when the MWCNTs are formed into an aqueous dispersion liquid having a specific concentration, and the size of a primary aggregate of the MWCNTs. In detail, it has been found that a larger scattering intensity ratio $S1/S2$ suggests that the variation in diameter of the MWCNTs is small, and that when the variation in diameter of the MWCNTs is small, the interaction force between the MWCNTs becomes greater, making the MWCNTs more likely to become entangled with each other and more likely to form a network structure.

The MWCNT assembly (B) according to the present disclosure is considered to have a small variation in diameter of the MWCNTs and to form a network structure in which the MWCNTs are entangled with each other. It is speculated that the formation of a network structure by the MWCNTs leads to multiple points of contact between the MWCNTs, resulting in the formation of a large conductive path, thereby increasing conductivity.

Another embodiment of the multi-walled carbon nanotube assembly according to the present disclosure is a multi-walled carbon nanotube assembly comprising multi-walled carbon nanotubes having a scattering intensity ratio $S3/S4$ of 10 or less, which is the ratio of the scattering intensity $S3$ at a scattering vector magnitude $q = 0.02$ $nm^{-1}$ to the scattering intensity $S4$ at a scattering vector magnitude $q = 0.08$ $nm^{-1}$ in a scattering profile obtained by a small-angle X-ray scattering method when formed into an aqueous dispersion liquid having a concentration of 0.2% by mass.

In the present disclosure, the multi-walled carbon nanotube assembly according to this embodiment is also referred to as "MWCNT assembly (C)".

The MWCNT assembly (C) according to the present disclosure has high conductivity.

The reason why the MWCNT assembly (C) according to the present disclosure has high conductivity is not clear, but the present inventors speculate as follows. However, the following speculation is not intended to limit the MWCNT assembly (C) according to the present disclosure, and is described merely as an example.

The present inventors have obtained findings regarding the relationship between the scattering intensity ratio $S3/S4$, which is the ratio of the scattering intensity $S3$ at a scattering vector magnitude $q = 0.02$ $nm^{-1}$ to the scattering intensity $S4$ at a scattering vector magnitude $q = 0.08$ $nm^{-1}$ in a scattering profile obtained by a small-angle X-ray scattering method when the MWCNTs are formed into an aqueous dispersion liquid having a specific concentration, and the entanglement of the MWCNTs. In detail, it has been found that a smaller scattering intensity ratio $S3/S4$ suggests that the size of a primary aggregate of the MWCNTs is small, and that when the size of a primary aggregate of the MWCNTs is small, the surface area of the MWCNTs increases, making the MWCNTs more likely to become entangled with each other and more likely to form a network structure.

The MWCNT assembly (C) according to the present disclosure is considered to have a small size of a primary aggregate of the MWCNTs and to form a network structure in which the MWCNTs are entangled with each other. It is speculated that the formation of a network structure by the MWCNTs leads to multiple points of contact between the MWCNTs, resulting in the formation of a large conductive path, thereby increasing conductivity.

In the MWCNT assembly according to the present disclosure, the entangled state of the MWCNTs can be confirmed by SEM observation.

The MWCNT assembly according to the present disclosure has high conductivity and is suitable as a conductive auxiliary agent, for example. In addition, since the MWCNT assembly according to the present disclosure is in a state where the MWCNTs are entangled with each other, it tends to be less prone to swelling phenomena even when in contact with an organic solvent. Therefore, when the MWCNTs according to the present disclosure are used as a conductive auxiliary agent in forming electrodes of secondary batteries such as lithium-ion batteries, for example, the structure is unlikely to change even when the battery is operated, and the durability of the battery can be improved.

Hereinafter, the MWCNT assembly (A) according to the present disclosure, the MWCNT assembly (B) according to the present disclosure, and the MWCNT assembly (C) according to the present disclosure will be described, and then, other possible aspects of the MWCNT assembly according to the present disclosure will be described.

[MWCNT assembly (A)]

The MWCNT assembly (A) according to the present disclosure comprises MWCNTs having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass.

The MWCNTs contained in the MWCNT assembly (A) according to the present disclosure are preferably in the form of fibers from the viewpoint of facilitating the formation of a network structure due to the entanglement of MWCNTs.

The maximum length of the MWCNTs contained in the MWCNT assembly (A) according to the present disclosure is not particularly limited, but for example, it is preferably 500 $\mu$m to 30000 $\mu$m, more preferably 1000 $\mu$m to 25000 $\mu$m, still more preferably 1100 $\mu$m to 20000 $\mu$m, particularly preferably 1200 $\mu$m to 18000 $\mu$m, and especially preferably 1300 $\mu$m to 15000 $\mu$m.

When the maximum length of the MWCNTs contained in the MWCNT assembly (A) according to the present disclosure is 500 $\mu$m or more, the conductivity of the MWCNT assembly (A) tends to further increase. This is considered to be because the MWCNTs contained in the MWCNT assembly (A) can come into contact with each other more easily, facilitating the formation of a conductive path.

The MWCNTs contained in the MWCNT assembly (A) according to the present disclosure tend to be easier to produce when their maximum length is 30000 $\mu$m or less.

In the present disclosure, the length of the MWCNTs can be measured by focusing on a single MWCNT and taking multiple SEM images with adjacent fields of view. Here, the term "length of the MWCNTs" refers to the measured value of the length in the longitudinal direction of the MWCNTs, and the maximum value among the measured values of the length is defined as the "maximum length".

For example, by taking SEM images of the MWCNT assembly, when one or more MWCNTs having a maximum length in the range of 500 $\mu$m to 30000 $\mu$m are observed within the field of view of a SEM image, it is determined that the observed MWCNT assembly contains MWCNTs having a maximum length of 500 $\mu$m to 30000 $\mu$m.

The length of the fibrous MWCNTs can be controlled, for example, by the winding capacity of the spindle used in producing the fibrous MWCNTs.

The MWCNT assembly (A) according to the present disclosure preferably comprises one or more MWCNTs having a maximum length of 500 $\mu$m to 30000 $\mu$m, and more preferably comprises multiple such MWCNTs.

In the present disclosure, the "MWCNTs having a maximum length of 500 $\mu$m to 30000 $\mu$m" are also referred to as "SLMWCNTs".

The proportion of the SLMWCNTs in the MWCNT assembly (A) according to the present disclosure is, for example, preferably 10% or more, more preferably 20% or more, still more preferably 30% or more, and particularly preferably 50% or more, based on the number.

When the proportion of the SLMWCNTs in the MWCNT assembly (A) according to the present disclosure is 10% or more based on the number, the stability of the MWCNT assembly (A) in the aqueous dispersion liquid due to the entanglement of MWCNTs tends to further improve.

In the present disclosure, the proportion of the SLMWCNTs in the MWCNT assembly is determined by taking multiple SEM images with adjacent fields of view, focusing on 100 MWCNTs included in the field of view of the SEM images, measuring their respective maximum lengths, and identifying MWCNTs having a maximum length in the range of 500 $\mu$m to 30000 $\mu$m (that is, SLMWCNTs) among the observed MWCNTs.

The same applies to the proportion of ULMWCNTs in the MWCNT assembly and the proportion of specific ULMWCNTs in the MWCNT assembly, which will be described later.

The diameter of the MWCNTs contained in the MWCNT assembly (A) according to the present disclosure is not particularly limited, but for example, it is preferably 1 nm to 100 nm, more preferably 2 nm to 80 nm, still more preferably 3 nm to 50 nm, and particularly preferably 5 nm to 30 nm.

In the present disclosure, the diameter of the MWCNTs can be measured by taking a SEM image or a transmission electron microscope (TEM) image. Here, the term "diameter" refers to the length in a direction orthogonal to the longitudinal direction of the MWCNTs, and the diameter of a single MWCNT is defined as the average value of diameters measured at ten different locations on that MWCNT.

The ratio of the length to the diameter (so-called aspect ratio) of the MWCNTs contained in the MWCNT assembly (A) according to the present disclosure is preferably 1000 or more, more preferably 3000 or more, still more preferably 5000 or more, and particularly preferably 10000 or more.

In the present disclosure, the aspect ratio of the MWCNTs can be calculated from the ratio of the maximum length to the diameter of a single MWCNT. From the viewpoint of measurement accuracy, it is preferable to employ the average value of the measured values of 20 or more MWCNTs.

The specific gravity of the MWCNT assembly (A) according to the present disclosure is not particularly limited, but for example, from the viewpoint of dispersibility when formed into an aqueous dispersion liquid, it is preferably 1.5 to 2.5, more preferably 1.7 to 2.4, and still more preferably 1.8 to 2.2.

In the present disclosure, the specific gravity of the MWCNT assembly (A) can be measured by the method described in JIS Z 8807:2012 "Methods of measuring density and specific gravity of solid".

The MWCNT assembly (A) according to the present disclosure comprises MWCNTs having a median diameter of 80 nm or more in a volume-based particle size distribution obtained by a centrifugal sedimentation method when formed into an aqueous dispersion liquid having a concentration of 0.004% by mass.

When the median diameter of the MWCNTs contained in the MWCNT assembly (A) according to the present disclosure is 80 nm or more, the conductivity of the MWCNT assembly (A) can be improved.

The median diameter of the MWCNTs contained in the MWCNT assembly (A) according to the present disclosure is preferably 90 nm or more, more preferably 100 nm or more, and still more preferably 150 nm or more.

The upper limit of the median diameter of the MWCNTs contained in the MWCNT assembly (A) according to the present disclosure is not particularly limited, but for example, from the viewpoint of dispersibility when formed into an aqueous dispersion liquid, it is preferably 1000 nm or less, more preferably 800 nm or less, and still more preferably 500 nm or less.

In the present disclosure, the median diameter in a volume-based particle size distribution obtained by a centrifugal sedimentation method when the MWCNTs are formed into an aqueous dispersion liquid having a concentration of 0.004% by mass is determined by the following method. Note that, in the present disclosure, the term "median diameter in a volume-based particle size distribution obtained by a centrifugal sedimentation method" means a particle diameter at which the cumulative frequency in a volume-based particle size distribution obtained by a centrifugal sedimentation method reaches 50% (so-called d50).

The MWCNTs and a dispersant are added to ion exchanged water, followed by a dispersion treatment to obtain an aqueous dispersion liquid of the MWCNTs. The amount of the MWCNTs added is such an amount that the concentration of the MWCNTs in the aqueous dispersion liquid is 0.004% by mass. The obtained aqueous dispersion liquid is used as a measurement sample, and a volume-based particle size distribution of the MWCNTs is measured using a centrifugal sedimentation particle size distribution measurement apparatus under the measurement conditions described below. In the measured volume-based particle size distribution, the particle diameter at which the cumulative frequency reaches 50% is read and defined as the median diameter.

As the centrifugal sedimentation particle size distribution measurement apparatus, LUMiSizer 611 (trade name), which is a centrifugal sedimentation dispersion stability particle diameter distribution apparatus manufactured by LUM GmbH, can be suitably used, for example. However, the centrifugal sedimentation particle size distribution measurement apparatus is not limited thereto.

<Measurement conditions>

Measurement cell: Polycarbonate cell (optical path length: 2 mm)
Rotation speed: 4000 rpm
Centrifugal acceleration: 2300 × g
Measurement interval: 30 seconds
Number of measurements: 1000 times
Measurement temperature: 25°C

The median diameter can be controlled by the synthesis conditions such as the calcination temperature, gas flow rate, and gas introduction method when synthesizing the MWCNTs.

For example, the median diameter can be increased by raising the calcination temperature during the synthesis of the MWCNTs, and can be decreased by lowering the calcination temperature during the synthesis of the MWCNTs.

The MWCNT assembly (A) according to the present disclosure comprises MWCNTs having a rate of change in transmittance of 0.3%/hour or less as measured by a centrifugal sedimentation method when formed into an aqueous dispersion liquid having a concentration of 0.2% by mass.

When the rate of change in transmittance of the MWCNTs contained in the MWCNT assembly (A) according to the present disclosure is 0.3%/hour or less, the stability of the MWCNT assembly (A) in the aqueous dispersion liquid is improved, and the conductivity can be improved.

The rate of change in transmittance of the MWCNTs contained in the MWCNT assembly (A) according to the present disclosure is preferably 0.25%/hour or less, more preferably 0.2%/hour or less, and still more preferably 0.15%/hour or less.

The lower limit of the rate of change in transmittance of the MWCNTs contained in the MWCNT assembly (A) according to the present disclosure is not particularly limited, but for example, from the viewpoint of ease of production, it is preferably 0.01%/hour or more, and more preferably 0.03%/hour or more.

In the present disclosure, the rate of change in transmittance as measured by a centrifugal sedimentation method when the MWCNTs are formed into an aqueous dispersion liquid having a concentration of 0.2% by mass is determined by the following method.

The MWCNTs and a dispersant are added to ion exchanged water, followed by a dispersion treatment to obtain an aqueous dispersion liquid of the MWCNTs. The amount of the MWCNTs added is such an amount that the concentration of the MWCNTs in the aqueous dispersion liquid is 0.2% by mass. The obtained aqueous dispersion liquid is used as a measurement sample, and a centrifugal sedimentation particle size distribution measurement apparatus is used to obtain a sedimentation profile under the measurement and analysis conditions described below. By analyzing the rate of change in overall transmittance from the obtained sedimentation profile, the rate of change in transmittance is determined.

As the centrifugal sedimentation particle size distribution measurement apparatus, LUMiSizer 611 (trade name), which is a centrifugal sedimentation dispersion stability particle diameter distribution apparatus manufactured by LUM GmbH, can be suitably used, for example. However, the centrifugal sedimentation particle size distribution measurement apparatus is not limited thereto.

<Measurement and analysis conditions>

Measurement cell: Polycarbonate cell (optical path length: 2 mm)
Rotation speed: 4000 rpm
Centrifugal acceleration: 2300 $\times$ g
Measurement interval: 30 seconds
Number of measurements: 1000 times
Viscosity of dispersion medium: 0.8946 mPa·s
Density of dispersion medium: 997.3 kg/m$^3$
Density of dispersoid: 1350 kg/m$^3$
Refractive index of dispersion medium (real part): 1.326
Refractive index of dispersoid (real part): 1.630
Refractive index of dispersion medium (imaginary part): 0.5153

In the analysis conditions described above, the dispersion medium is water and the dispersoid is the MWCNTs.

The values of the viscosity, density, and refractive index described above are all values at 25°C.

The rate of change in transmittance can be controlled by the synthesis conditions such as the calcination temperature, gas flow rate, and gas introduction method when synthesizing the MWCNTs.

For example, the rate of change in transmittance can be increased by increasing the gas flow rate during the synthesis of the MWCNTs, and can be decreased by decreasing the gas flow rate during the synthesis of the MWCNTs.

[MWCNT assembly (B)]

The MWCNT assembly (B) according to the present disclosure comprises MWCNTs having a scattering intensity ratio S1/S2 of 90 or more, which is the ratio of the scattering intensity S1 at a scattering vector magnitude q = 0.2 nm$^{-1}$ to the scattering intensity S2 at a scattering vector magnitude q = 0.8 nm$^{-1}$ in a scattering profile obtained by a small-angle X-ray scattering method when formed into an aqueous dispersion liquid having a concentration of 0.2% by mass.

The MWCNTs contained in the MWCNT assembly (B) according to the present disclosure are preferably in the form of fibers from the viewpoint of facilitating the formation of a network structure due to the entanglement of MWCNTs.

The maximum length of the MWCNTs contained in the MWCNT assembly (B) according to the present disclosure is not particularly limited, but for example, it is preferably 500 μm to 30000 μm, more preferably 1000 μm to 25000 μm, still more preferably 1100 μm to 20000 μm, particularly preferably 1200 μm to 18000 μm, and especially preferably 1300 μm to 15000 μm.

When the maximum length of the MWCNTs contained in the MWCNT assembly (B) according to the present disclosure is 500 μm or more, the conductivity of the MWCNT assembly (B) tends to further increase. This is considered to be because the MWCNTs contained in the MWCNT assembly (B) can come into contact with each other more easily, facilitating the formation of a conductive path.

The MWCNTs contained in the MWCNT assembly (B) according to the present disclosure tend to be easier to produce when their maximum length is 30000 μm or less.

The MWCNT assembly (B) according to the present disclosure preferably comprises one or more MWCNTs having a maximum length of 500 μm to 30000 μm (that is, SLMWCNTs), and more preferably comprises multiple such MWCNTs.

The proportion of the SLMWCNTs in the MWCNT assembly (B) according to the present disclosure is, for example, preferably 10% or more, more preferably 20% or more, still more preferably 30% or more, and particularly preferably 50% or more, based on the number.

When the proportion of the SLMWCNTs in the MWCNT assembly (B) according to the present disclosure is 10% or more based on the number, the stability of the MWCNT assembly (B) in the aqueous dispersion liquid due to the entanglement of MWCNTs tends to further improve.

The diameter of the MWCNTs contained in the MWCNT assembly (B) according to the present disclosure is not particularly limited, but for example, it is preferably 1 nm to 100 nm, more preferably 2 nm to 80 nm, still more preferably 3 nm to 50 nm, and particularly preferably 5 nm to 30 nm.

The ratio of the length to the diameter (so-called aspect ratio) of the MWCNTs contained in the MWCNT assembly (B) according to the present disclosure is preferably 1000 or more, more preferably 3000 or more, still more preferably 5000 or more, and particularly preferably 10000 or more.

The specific gravity of the MWCNT assembly (B) according to the present disclosure is not particularly limited, but for example, from the viewpoint of dispersibility when formed into an aqueous dispersion liquid, it is preferably 1.5 to 2.5, more preferably 1.7 to 2.4, and still more preferably 1.8 to 2.2.

The MWCNT assembly (B) according to the present disclosure comprises MWCNTs having a scattering intensity ratio S1/S2 of 90 or more in a scattering profile obtained by a small-angle X-ray scattering method when formed into an aqueous dispersion liquid having a concentration of 0.2% by mass.

When the scattering intensity ratio S1/S2 of the MWCNTs contained in the MWCNT assembly (B) according to the present disclosure is 90 or more, the conductivity of the MWCNT assembly (B) can be improved.

The scattering intensity ratio S1/S2 of the MWCNTs contained in the MWCNT assembly (B) according to the present disclosure is preferably 95 or more, more preferably 98 or more, still more preferably 100 or more, and particularly preferably 110 or more.

The upper limit of the scattering intensity ratio S1/S2 of the MWCNTs contained in the MWCNT assembly (B) according to the present disclosure is not particularly limited, but for example, from the viewpoint of ease of production, it is preferably 250 or less, and more preferably 200 or less.

The scattering intensity ratio S1/S2 can be controlled by the synthesis conditions such as the calcination temperature, gas flow rate, and gas introduction method when synthesizing the MWCNTs.

For example, the scattering intensity ratio S1/S2 can be increased by raising the calcination temperature during the synthesis of the MWCNTs, and can be decreased by lowering the calcination temperature during the synthesis of the MWCNTs.

[MWCNT assembly (C)]

The MWCNT assembly (C) according to the present disclosure comprises MWCNTs having a scattering intensity ratio S3/S4 of 10 or less, which is the ratio of the scattering intensity S3 at a scattering vector magnitude $q = 0.02$ nm$^{-1}$ to the scattering intensity S4 at a scattering vector magnitude $q = 0.08$ nm$^{-1}$ in a scattering profile obtained by a small-angle X-ray scattering method when formed into an aqueous dispersion liquid having a concentration of 0.2% by mass.

The MWCNTs contained in the MWCNT assembly (C) according to the present disclosure are preferably in the form of fibers from the viewpoint of facilitating the formation of a network structure due to the entanglement of MWCNTs.

The maximum length of the MWCNTs contained in the MWCNT assembly (C) according to the present disclosure is not particularly limited, but for example, it is preferably 500 μm to 30000 μm, more preferably 1000 μm to 25000 μm, still more preferably 1100 μm to 20000 μm, particularly preferably 1200 μm to 18000 μm, and especially preferably 1300 μm to 15000 μm.

When the maximum length of the MWCNTs contained in the MWCNT assembly (C) according to the present

disclosure is 500 μm or more, the conductivity of the MWCNT assembly (C) tends to further increase. This is considered to be because the MWCNTs contained in the MWCNT assembly (C) can come into contact with each other more easily, facilitating the formation of a conductive path.

The MWCNTs contained in the MWCNT assembly (C) according to the present disclosure tend to be easier to produce when their maximum length is 30000 μm or less.

The MWCNT assembly (C) according to the present disclosure preferably comprises one or more MWCNTs having a maximum length of 500 μm to 30000 μm (that is, SLMWCNTs), and more preferably comprises multiple such MWCNTs.

The proportion of the SLMWCNTs in the MWCNT assembly (C) according to the present disclosure is, for example, preferably 10% or more, more preferably 20% or more, still more preferably 30% or more, and particularly preferably 50% or more, based on the number.

When the proportion of the SLMWCNTs in the MWCNT assembly (C) according to the present disclosure is 10% or more based on the number, the stability of the MWCNT assembly (C) in the aqueous dispersion liquid due to the entanglement of MWCNTs tends to further improve.

The diameter of the MWCNTs contained in the MWCNT assembly (C) according to the present disclosure is not particularly limited, but for example, it is preferably 1 nm to 100 nm, more preferably 2 nm to 80 nm, still more preferably 3 nm to 50 nm, and particularly preferably 5 nm to 30 nm.

The ratio of the length to the diameter (so-called aspect ratio) of the MWCNTs contained in the MWCNT assembly (C) according to the present disclosure is preferably 1000 or more, more preferably 3000 or more, still more preferably 5000 or more, and particularly preferably 10000 or more.

The specific gravity of the MWCNT assembly (C) according to the present disclosure is not particularly limited, but for example, from the viewpoint of dispersibility when formed into an aqueous dispersion liquid, it is preferably 1.5 to 2.5, more preferably 1.7 to 2.4, and still more preferably 1.8 to 2.2.

The MWCNT assembly (C) according to the present disclosure comprises MWCNTs having a scattering intensity ratio S3/S4 of 10 or less in a scattering profile obtained by a small-angle X-ray scattering method when formed into an aqueous dispersion liquid having a concentration of 0.2% by mass.

When the scattering intensity ratio S3/S4 of the MWCNTs contained in the MWCNT assembly (C) according to the present disclosure is 10 or less, the conductivity of the MWCNT assembly (C) can be improved.

The scattering intensity ratio S3/S4 of the MWCNTs contained in the MWCNT assembly (C) according to the present disclosure is preferably 9.5 or less, more preferably 9 or less, and still more preferably 8.5 or less.

The lower limit of the scattering intensity ratio S3/S4 of the MWCNTs contained in the MWCNT assembly (C) according to the present disclosure is not particularly limited, but for example, from the viewpoint of ease of production, it is preferably 1 or more, and more preferably 4 or more.

The scattering intensity ratio S3/S4 can be controlled by the synthesis conditions such as the calcination temperature, gas flow rate, and gas introduction method when synthesizing the MWCNTs.

For example, the scattering intensity ratio S3/S4 can be increased by increasing the gas flow rate during the synthesis of the MWCNTs, and can be decreased by decreasing the gas flow rate during the synthesis of the MWCNTs.

In the present disclosure, the scattering intensity ratio S1/S2, which is the ratio of the scattering intensity S1 at a scattering vector magnitude $q = 0.2$ nm$^{-1}$ to the scattering intensity S2 at a scattering vector magnitude $q = 0.8$ nm$^{-1}$ in a scattering profile obtained by a small-angle X-ray scattering method, and the scattering intensity ratio S3/S4, which is the ratio of the scattering intensity S3 at a scattering vector magnitude $q = 0.02$ nm$^{-1}$ to the scattering intensity S4 at a scattering vector magnitude $q = 0.08$ nm$^{-1}$ in the scattering profile obtained by a small-angle X-ray scattering method, when the MWCNTs are formed into an aqueous dispersion liquid having a concentration of 0.2% by mass are determined by the following method.

The MWCNTs and a dispersant are added to ion exchanged water, followed by a dispersion treatment to obtain an aqueous dispersion liquid of the MWCNTs. The amount of the MWCNTs added is such an amount that the concentration of the MWCNTs in the aqueous dispersion liquid is 0.2% by mass. The obtained aqueous dispersion liquid is used as a measurement sample.

The measurement sample is filled into a NMR tube with an outer diameter of 2.99 ± 0.03 mm and an inner diameter of 2.41 ± 0.03 mm (trade name: S-3-HT-7, manufactured by NORELL, Inc.) without introducing bubbles, and a scattering profile of the MWCNTs is then obtained using a small-angle X-ray scattering apparatus.

The measurement by the small-angle X-ray scattering method is performed in accordance with the description in "Structural Science of Crystalline Polymers, Kohji Tashiro, Springer, 2022".

More specifically, X-rays are incident in a direction perpendicular to the length direction near the axis center of the NMR tube. The irradiation position is shifted by 100 μm along the length direction with an exposure time of 1 second, and 10 measurements are performed to obtain a total two-dimensional scattering image Ms. At the same time as capturing the two-dimensional scattering image, a transmitted light intensity fs is measured at an ion chamber downstream of the NMR tube. Under the same conditions as described above except that ion exchanged water is filled in the NMR tube instead of the aqueous dispersion liquid, a background two-dimensional scattering image Mb and a transmitted light intensity fb are measured.

According to the following expression (1), a background-corrected two-dimensional scattering image M is obtained. At this time, the range where scattered X-rays are blocked by a beam stopper or the like provided to prevent the direct beam from entering the detector is excluded from the two-dimensional scattering image M.

$$M = Ms/fs - Mb/fb \qquad (1)$$

A one-dimensional profile in the radial direction is obtained from the two-dimensional scattering image M by annular averaging. Note that the horizontal axis is calibrated to the scattering vector magnitude q using collagen as a standard substance.

From the obtained one-dimensional profile, the scattering intensity S1 at a scattering vector magnitude q = 0.2 $nm^{-1}$, the scattering intensity S2 at a scattering vector magnitude q = 0.8 $nm^{-1}$, the scattering intensity S3 at a scattering vector magnitude q = 0.02 $nm^{-1}$, and the scattering intensity S4 at a scattering vector magnitude q = 0.08 $nm^{-1}$ are read, and the scattering intensity ratio S1/S2 and the scattering intensity ratio S3/S4 are determined.

As the small-angle X-ray scattering experimental facility, the BL03XU beamline of SPring-8, which is a large synchrotron radiation facility, can be suitably used, for example. However, the small-angle X-ray scattering experimental facility is not limited thereto. Alternatively, NANOPIX (trade name), which is a small-angle X-ray scattering apparatus manufactured by Rigaku Corporation, for example, may be used instead of the large synchrotron radiation facility.

As the wavelength of the X-rays, 0.03 nm to 0.13 nm is preferable. As the beam diameter, 1 $\mu$m to 100 $\mu$m is preferable. As the measurement temperature, 20°C to 30°C is preferable. As the camera length, 8000 mm is preferable. However, the measurement may be separately performed with a camera length that includes both a scattering vector magnitude q = 0.2 $nm^{-1}$ and a scattering vector magnitude q = 0.8 $nm^{-1}$, for example, 700 mm to 8000 mm, and with a camera length that includes both a scattering vector magnitude q = 0.02 $nm^{-1}$ and a scattering vector magnitude q = 0.08 $nm^{-1}$, for example, 8000 mm to 20000 mm.

As the detector, PILATUS 1M (trade name) manufactured by Dectris Ltd. can be suitably used, for example. However, the detector is not limited thereto.

Examples of preferred aspects of the multi-walled carbon nanotube assembly according to the present disclosure include the following aspect 1, aspect 2, and aspect 3. The details of the respective requirements in the aspects 1, 2, and 3 are the same as the details of the respective requirements in the aspect of MWCNT assembly (A), the aspect of MWCNT assembly (B), and the aspect of MWCNT assembly (C).

The preferred aspect 1 of the multi-walled carbon nanotube assembly according to the present disclosure is an aspect comprising multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass, and having a scattering intensity ratio S1/S2 of 90 or more, which is the ratio of the scattering intensity S1 at a scattering vector magnitude q = 0.2 $nm^{-1}$ to the scattering intensity S2 at a scattering vector magnitude q = 0.8 $nm^{-1}$ in a scattering profile obtained by a small-angle X-ray scattering method when formed into an aqueous dispersion liquid having a concentration of 0.2% by mass.

The aspect 1 is an aspect in which the aspect of MWCNT assembly (A) according to the present disclosure and the aspect of MWCNT assembly (B) according to the present disclosure are combined.

The preferred aspect 2 of the multi-walled carbon nanotube assembly according to the present disclosure is an aspect comprising multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass, and having a scattering intensity ratio S3/S4 of 10 or less, which is the ratio of the scattering intensity S3 at a scattering vector magnitude q = 0.02 $nm^{-1}$ to the scattering intensity S4 at a scattering vector magnitude q = 0.08 $nm^{-1}$ in a scattering profile obtained by a small-angle X-ray scattering method when formed into an aqueous dispersion liquid having a concentration of 0.2% by mass.

The aspect 2 is an aspect in which the aspect of MWCNT assembly (A) according to the present disclosure and the aspect of MWCNT assembly (C) according to the present disclosure are combined.

The preferred aspect 3 of the multi-walled carbon nanotube assembly according to the present disclosure is an aspect comprising multi-walled carbon nanotubes having a scattering intensity ratio S1/S2 of 90 or more, which is the ratio of the scattering intensity S1 at a scattering vector magnitude q = 0.2 $nm^{-1}$ to the scattering intensity S2 at a scattering vector magnitude q = 0.8 $nm^{-1}$ in a scattering profile obtained by a small-angle X-ray scattering method, and having a scattering intensity ratio S3/S4 of 10 or less, which is the ratio of the scattering intensity S3 at a scattering vector magnitude q = 0.02 nm$^{-1}$ to the scattering intensity S4 at a scattering vector magnitude q = 0.08 nm$^{-1}$ in the scattering profile, when formed into an aqueous dispersion liquid having a concentration of 0.2% by mass.

The aspect 3 is an aspect in which the aspect of MWCNT assembly (B) according to the present disclosure and the aspect of MWCNT assembly (C) according to the present disclosure are combined.

[MWCNT assembly (D)]

In an aspect, the multi-walled carbon nanotube assembly according to the present disclosure comprises multi-walled carbon nanotubes having a maximum length of 1000 μm to 30000 μm, wherein the peak intensity ratio G1/D1, which is the ratio of the peak intensity G1 of the G band to the peak intensity D1 of the D band in a Raman spectrum of the multi-walled carbon nanotubes, is more than 0.9 and 15 or less, and the multi-walled carbon nanotubes have a BET specific surface area of 50 m$^2$/g to 400 m$^2$/g.

In the present disclosure, the multi-walled carbon nanotube assembly according to this aspect is also referred to as "MWCNT assembly (D)". In the present disclosure, the "MWCNTs having a maximum length of 1000 μm to 30000 μm" are also referred to as "ULMWCNTs".

The MWCNT assembly (D) according to the present disclosure has high conductivity.

The reason why the MWCNT assembly (D) according to the present disclosure has high conductivity is not clear, but the present inventors speculate as follows. However, the following speculation is not intended to limit the MWCNT assembly (D) according to the present disclosure, and is described merely as an example.

Since the MWCNT assembly (D) according to the present disclosure comprises MWCNTs having a maximum length of 1000 μm to 30000 μm (that is, ULMWCNTs), it is considered that the MWCNTs are likely to come into contact with each other. When the MWCNTs are likely to come into contact with each other, a conductive path is easily formed, and the conductivity can be improved. Also, as for the MWCNTs contained in the MWCNT assembly (D) according to the present disclosure, the peak intensity ratio G1/D1, which is the ratio of the peak intensity G1 of the G band to the peak intensity D1 of the D band in a Raman spectrum, is equal to or more than the specific value, and the number of defects present in the MWCNTs is relatively small. A smaller number of defects present in the MWCNTs can improve conductivity. In addition, as for the MWCNTs contained in the MWCNT assembly (D) according to the present disclosure, the peak intensity ratio G1/D1 is equal to or less than the specific value and their shapes are relatively non-uniform, and therefore, the MWCNTs tend to become entangled with each other. As the entanglement of the MWCNTs with each other occurs more, the conductivity can be improved. Furthermore, the MWCNTs contained in the MWCNT assembly (D) according to the present disclosure have a moderately large BET specific surface area, and therefore, the MWCNTs are considered to come into close contact with each other. When the MWCNTs come into close contact with each other, the volume resistivity of the MWCNTs decreases, and the conductivity can be improved.

From the above, the MWCNT assembly (D) according to the present disclosure is speculated to have high conductivity.

The ULMWCNTs contained in the MWCNT assembly (D) according to the present disclosure can take a fibrous shape. By taking a fibrous shape, the ULMWCNTs have a property of easily becoming entangled with each other. Therefore, in the MWCNT assembly (D) according to the present disclosure, a network structure due to the entanglement of MWCNTs is likely to be formed.

The MWCNT assembly (D) according to the present disclosure comprises MWCNTs having a maximum length of 1000 μm to 30000 μm (that is, ULMWCNTs). The ULMWCNTs are longer in length compared to general-purpose MWCNTs.

By comprising MWCNTs having a maximum length of 1000 μm or more, the MWCNT assembly (D) according to the present disclosure tends to have increased conductivity. This is considered to be because the MWCNTs contained in the MWCNT assembly (D) can come into contact with each other easily, facilitating the formation of a conductive path.

The MWCNTs contained in the MWCNT assembly (D) according to the present disclosure tend to be easier to produce when their maximum length is 30000 μm or less.

The MWCNT assembly (D) according to the present disclosure preferably comprises MWCNTs having a maximum length of 1050 μm to 25000 μm, more preferably comprises MWCNTs having a maximum length of 1100 μm to 20000 μm, still more preferably comprises MWCNTs having a maximum length of 1200 μm to 18000 μm, and particularly preferably comprises MWCNTs having a maximum length of 1300 μm to 15000 μm.

The MWCNT assembly (D) according to the present disclosure comprises one or more MWCNTs having a maximum length of 1000 μm to 30000 μm (that is, ULMWCNTs), and preferably comprises multiple such MWCNTs.

The proportion of the ULMWCNTs in the MWCNT assembly (D) according to the present disclosure is, for example, preferably 10% or more, more preferably 20% or more, still more preferably 30% or more, and particularly preferably 50% or more, based on the number.

When the proportion of the ULMWCNTs in the MWCNT assembly (D) according to the present disclosure is 10% or more based on the number, the stability of the MWCNT assembly (D) in the aqueous dispersion liquid due to the entanglement of MWCNTs tends to further improve.

The diameter of the MWCNTs contained in the MWCNT assembly (D) according to the present disclosure is not particularly limited, but for example, it is preferably 1 nm to 100 nm, more preferably 2 nm to 80 nm, still more preferably 3 nm to 50 nm, and particularly preferably 5 nm to 30 nm.

The ratio of the length to the diameter (so-called aspect ratio) of the MWCNTs contained in the MWCNT assembly (D) according to the present disclosure is preferably 1000 or more, more preferably 3000 or more, still more preferably 5000 or more, and particularly preferably 10000 or more.

The specific gravity of the MWCNT assembly (D) according to the present disclosure is not particularly limited, but for example, from the viewpoint of dispersibility when formed into an aqueous dispersion liquid, it is preferably 1.5 to 2.5, more preferably 1.7 to 2.4, and still more preferably 1.8 to 2.2.

In the MWCNTs contained in the MWCNT assembly (D) according to the present disclosure, the peak intensity ratio G1/D1, which is the ratio of the peak intensity G1 of the G band to the peak intensity D1 of the D band in a Raman spectrum, is more than 0.9 and 15 or less, preferably 1.0 or more and 14 or less, more preferably 1.2 or more and 13 or less, still more preferably 1.3 or more and 12 or less, and particularly preferably 1.5 or more and 12 or less.

When the peak intensity ratio G1/D1 of the MWCNTs contained in the MWCNT assembly (D) according to the present disclosure is more than 0.9, the number of defects present in the MWCNTs decreases, and the conductivity tends to be improved.

When the peak intensity ratio G1/D1 of the MWCNTs contained in the MWCNT assembly (D) according to the present disclosure is 15 or less, the uniformity of their shapes is disturbed, and the MWCNTs tend to become entangled with each other.

In the present disclosure, the peak intensity ratio G1/D1, which is the ratio of the peak intensity G1 of the G band to the peak intensity D1 of the D band in a Raman spectrum of the MWCNTs, is determined by the following method.

The Raman spectrum of the MWCNTs is obtained using a Raman spectrometer under the measurement conditions described below. From the obtained Raman spectrum, the peak intensity G1 of the G band and the peak intensity D1 of the D band are read, and the peak intensity ratio G1/D1 is determined.

As the Raman spectrometer, for example, RAMAN-11 (trade name), which is a Raman spectrometer manufactured by Nanophoton, can be suitably used. However, the Raman spectrometer is not limited thereto.

<Measurement conditions>

Excitation laser wavelength: 532 nm
Grating: 600 grooves/mm
Objective lens: 20x, numerical aperture (N.A.) 0.45

In the present disclosure, the peak intensity G1 of the G band in a Raman spectrum means the maximum value of scattering intensity at a Raman shift of 1550 $cm^{-1}$ to 1600 $cm^{-1}$. Also, in the present disclosure, the peak intensity D1 of the D band in a Raman spectrum means the maximum value of scattering intensity at a Raman shift of 1300 $cm^{-1}$ to 1400 $cm^{-1}$.

The peak intensity ratio G1/D1, which is the ratio of the peak intensity G1 of the G band to the peak intensity D1 of the D band in a Raman spectrum of the MWCNTs, can be controlled by the synthesis conditions such as the calcination temperature, gas flow rate, and gas introduction method when synthesizing the MWCNTs.

For example, the peak intensity ratio G1/D1 can be increased by raising the calcination temperature during the synthesis of the MWCNTs, and can be decreased by lowering the calcination temperature during the synthesis of the MWCNTs.

The BET specific surface area of the MWCNTs contained in the MWCNT assembly (D) according to the present disclosure is 50 $m^2/g$ to 400 $m^2/g$, preferably 60 $m^2/g$ to 350 $m^2/g$, more preferably 70 $m^2/g$ to 300 $m^2/g$, still more preferably 80 $m^2/g$ to 280 $m^2/g$, and particularly preferably 100 $m^2/g$ to 250 $m^2/g$.

When the BET specific surface area of the MWCNTs contained in the MWCNT assembly (D) according to the present disclosure is 50 $m^2/g$ or more, the conductivity of the MWCNT assembly (D) tends to increase. This is considered to be because the contact between the MWCNTs becomes closer, thereby decreasing the volume resistivity of the MWCNTs.

When the BET specific surface area of the MWCNTs contained in the MWCNT assembly (D) according to the present disclosure is 400 $m^2/g$ or less, the MWCNTs are less likely to aggregate in an aqueous dispersion liquid, and the dispersibility of the MWCNTs tends to increase.

In the present disclosure, the BET specific surface area of the MWCNTs is determined by a gas adsorption method using nitrogen gas in accordance with JIS Z 8830:2013. Specifically, the MWCNTs are packed into a sample tube, and a pretreatment is performed on the MWCNTs by vacuum degassing the inside of the sample tube at 300°C for 3 hours using a pretreatment apparatus. The pretreated MWCNTs are used as a measurement sample, and the amount of nitrogen adsorption of the MWCNTs is measured under the measurement conditions described below using a specific surface area measurement apparatus to obtain an adsorption-desorption isotherm. From the obtained adsorption-desorption isotherm, the BET specific surface area is determined under the analysis conditions described below.

As the specific surface area measurement apparatus and the pretreatment apparatus, for example, BELSORP-mini II (trade name), which is a specific surface area measurement apparatus manufactured by MicrotracBEL Corp., and BELPREP-vac II (trade name), which is a pretreatment apparatus manufactured by MicrotracBEL Corp., can be suitably used. However, the specific surface area measurement apparatus and the pretreatment apparatus are not limited thereto.

<Measurement and analysis conditions>

Measurement method: Constant volume method
Adsorption temperature: 77 K
Adsorbate: Nitrogen
Saturation vapor pressure: Measured value
Equilibrium waiting time: 500 sec
Specific surface area: BET method (BET-Plot)

The BET specific surface area of the MWCNTs can be controlled by the synthesis conditions such as the calcination temperature, gas flow rate, and gas introduction method when synthesizing the MWCNTs.

For example, the BET specific surface area of the MWCNTs can be increased by raising the calcination temperature during the synthesis of the MWCNTs, and can be decreased by lowering the calcination temperature during the synthesis of the MWCNTs.

The MWCNT assembly (D) according to the present disclosure may comprise MWCNTs other than the ULMWCNTs to the extent that the effects thereof are not impaired. The MWCNTs other than the ULMWCNTs may be MWCNTs having a maximum length of less than 1000 $\mu$m or may be MWCNTs having a maximum length of more than 30000 $\mu$m.

Also, the MWCNT assembly (D) according to the present disclosure may comprise MWCNTs in which the peak intensity ratio G1/D1, which is the ratio of the peak intensity G1 of the G band to the peak intensity D1 of the D band in a Raman spectrum, is 0.9 or less, and may comprise MWCNTs in which the peak intensity ratio G1/D1 is more than 15, to the extent that the effects thereof are not impaired.

In addition, the MWCNT assembly (D) according to the present disclosure may comprise MWCNTs having a BET specific surface area of less than 50 $m^2$/g, and may comprise MWCNTs having a BET specific surface area of more than 400 $m^2$/g, to the extent that the effects thereof are not impaired.

[MWCNT assembly (E)]

In an aspect, the multi-walled carbon nanotube assembly according to the present disclosure comprises multi-walled carbon nanotubes having a maximum length of more than 1600 $\mu$m and 30000 $\mu$m or less, wherein the peak intensity ratio G1/D1, which is the ratio of the peak intensity G1 of the G band to the peak intensity D1 of the D band in a Raman spectrum of the multi-walled carbon nanotubes, is 10 or less, and the multi-walled carbon nanotubes have a BET specific surface area of 200 $m^2$/g to 300 $m^2$/g.

In the present disclosure, the multi-walled carbon nanotube assembly according to this aspect is also referred to as "MWCNT assembly (E)". In the present disclosure, the "MWCNTs having a maximum length of 1600 $\mu$m to 30000 $\mu$m" are also referred to as "specific ULMWCNTs".

The MWCNT assembly (E) according to the present disclosure has high conductivity.

The reason why the MWCNT assembly (E) according to the present disclosure has high conductivity is not clear, but the present inventors speculate as follows. However, the following speculation is not intended to limit the MWCNT assembly (E) according to the present disclosure, and is described merely as an example.

Since the MWCNT assembly (E) according to the present disclosure comprises MWCNTs having a maximum length of 1600 $\mu$m to 30000 $\mu$m (that is, specific ULMWCNTs), it is considered that the MWCNTs are likely to come into contact with each other. When the MWCNTs are likely to come into contact with each other, a conductive path is easily formed, and the conductivity can be improved. Also, as for the MWCNTs contained in the MWCNT assembly (E) according to the present disclosure, the peak intensity ratio G1/D1, which is the ratio of the peak intensity G1 of the G band to the peak intensity D1 of the D band in a Raman spectrum, is equal to or less than the specific value and their shapes are relatively non-uniform, and therefore, the MWCNTs tend to become entangled with each other. As the entanglement of the MWCNTs with each other occurs more, the conductivity can be improved. Furthermore, the MWCNTs contained in the MWCNT assembly (E) according to the present disclosure have a moderately large BET specific surface area, and therefore, the MWCNTs are considered to come into close contact with each other. When the MWCNTs come into close contact with each other, the surface resistivity of the MWCNTs decreases, and the conductivity can be improved. From the above, the MWCNT assembly (E) according to the present disclosure is speculated to have high conductivity.

The specific ULMWCNTs contained in the MWCNT assembly (E) according to the present disclosure can take a fibrous shape. By taking a fibrous shape, the specific ULMWCNTs have a property of easily becoming entangled with each other. Therefore, in the MWCNT assembly (E) according to the present disclosure, a network structure due to the entanglement of MWCNTs is likely to be formed.

The MWCNT assembly (E) according to the present disclosure comprises MWCNTs having a maximum length of 1600 $\mu$m to 30000 $\mu$m (that is, specific ULMWCNTs). The specific ULMWCNTs are much longer in length compared to general-purpose MWCNTs.

By comprising MWCNTs having a maximum length of 1600 $\mu$m or more, the MWCNT assembly (E) according to the present disclosure tends to have increased conductivity. This is considered to be because the MWCNTs contained in the MWCNT assembly (E) can come into contact with each other easily, facilitating the formation of a conductive path.

The MWCNTs contained in the MWCNT assembly (E) according to the present disclosure tend to be easier to produce when their maximum length is 30000 $\mu$m or less.

The MWCNT assembly (E) according to the present disclosure preferably comprises MWCNTs having a maximum length of 1700 $\mu$m to 25000 $\mu$m, more preferably comprises MWCNTs having a maximum length of 1800 $\mu$m to 20000 $\mu$m, still more preferably comprises MWCNTs having a maximum length of 1900 $\mu$m to 18000 $\mu$m, and particularly preferably comprises MWCNTs having a maximum length of 2000 $\mu$m to 15000 $\mu$m.

The MWCNT assembly (E) according to the present disclosure comprises one or more MWCNTs having a maximum length of 1600 $\mu$m to 30000 $\mu$m (that is, specific ULMWCNTs), and preferably comprises multiple such MWCNTs.

The proportion of the specific ULMWCNTs in the MWCNT assembly (E) according to the present disclosure is, for example, preferably 10% or more, more preferably 20% or more, still more preferably 30% or more, and particularly preferably 50% or more, based on the number.

When the proportion of the specific ULMWCNTs in the MWCNT assembly (E) according to the present disclosure is 10% or more based on the number, the stability of the MWCNT assembly (E) in the aqueous dispersion liquid due to the entanglement of MWCNTs tends to further improve.

The diameter of the MWCNTs contained in the MWCNT assembly (E) according to the present disclosure is not particularly limited, but for example, it is preferably 1 nm to 100 nm, more preferably 2 nm to 80 nm, still more preferably 3 nm to 50 nm, and particularly preferably 5 nm to 30 nm.

The ratio of the length to the diameter (so-called aspect ratio) of the MWCNTs contained in the MWCNT assembly (E) according to the present disclosure is preferably 1000 or more, more preferably 3000 or more, still more preferably 5000 or more, and particularly preferably 10000 or more.

The specific gravity of the MWCNT assembly (E) according to the present disclosure is not particularly limited, but for example, from the viewpoint of dispersibility when formed into an aqueous dispersion liquid, it is preferably 1.5 to 2.5, more preferably 1.7 to 2.4, and still more preferably 1.8 to 2.2.

In the MWCNTs contained in the MWCNT assembly (E) according to the present disclosure, the peak intensity ratio G1/D1, which is the ratio of the peak intensity G1 of the G band to the peak intensity D1 of the D band in a Raman spectrum, is 10 or less, preferably 9 or less, and more preferably 8 or less.

When the peak intensity ratio G1/D1 of the MWCNTs contained in the MWCNT assembly (E) according to the present disclosure is 10 or less, the uniformity of their shapes is disturbed, and the MWCNTs tend to become entangled with each other.

The lower limit of the peak intensity ratio G1/D1 of the MWCNTs contained in the MWCNT assembly (E) according to the present disclosure is not particularly limited, but for example, from the viewpoint of improvement in conductivity due to a reduction in defects present in the MWCNTs, it is preferably 1 or more, more preferably 1.5 or more, and still more preferably 2 or more.

The peak intensity ratio G1/D1 of the MWCNTs contained in the MWCNT assembly (E) according to the present disclosure may be 1 to 10, may be 1.5 to 9, or may be 2 to 8, for example.

The BET specific surface area of the MWCNTs contained in the MWCNT assembly (E) according to the present disclosure is 200 m$^2$/g to 300 m$^2$/g, preferably 205 m$^2$/g to 290 m$^2$/g, more preferably 210 m$^2$/g to 280 m$^2$/g, and still more preferably 220 m$^2$/g to 275 m$^2$/g.

When the BET specific surface area of the MWCNTs contained in the MWCNT assembly (E) according to the present disclosure is 200 m$^2$/g or more, the conductivity of the MWCNT assembly (E) tends to increase. This is considered to be because the contact between the MWCNTs becomes closer, thereby decreasing the surface resistivity of the MWCNTs.

When the BET specific surface area of the MWCNTs contained in the MWCNT assembly (E) according to the present disclosure is 300 m$^2$/g or less, the MWCNTs are less likely to aggregate in an aqueous dispersion liquid, and the dispersibility of the MWCNTs tends to increase.

The BET specific surface area of the MWCNTs can be controlled by the synthesis conditions such as the calcination temperature, gas flow rate, and gas introduction method when synthesizing the MWCNTs.

For example, the BET specific surface area of the MWCNTs can be increased by raising the calcination temperature during the synthesis of the MWCNTs, and can be decreased by lowering the calcination temperature.

The MWCNT assembly (E) according to the present disclosure may comprise MWCNTs other than the specific ULMWCNTs to the extent that the effects thereof are not impaired. The MWCNTs other than the specific ULMWCNTs may be MWCNTs having a maximum length of less than 1600 μm or may be MWCNTs having a maximum length of more than 30000 μm.

Also, the MWCNT assembly (E) according to the present disclosure may comprise MWCNTs in which the peak intensity ratio G1/D1, which is the ratio of the peak intensity G1 of the G band to the peak intensity D1 of the D band in a Raman spectrum, is more than 10, to the extent that the effects thereof are not impaired.

In addition, the MWCNT assembly (E) according to the present disclosure may comprise MWCNTs having a BET specific surface area of less than 200 m$^2$/g, and may comprise MWCNTs having a BET specific surface area of more than 300 m$^2$/g, to the extent that the effects thereof are not impaired.

<<Applications of multi-walled carbon nanotube assembly>>

The applications of the MWCNT assembly according to the present disclosure are not particularly limited.

Since the MWCNT assembly according to the present disclosure has high conductivity, it can be suitably used as, for example, a conductive auxiliary agent (in particular, a conductive auxiliary agent for a negative electrode).

Since the MWCNT assembly according to the present disclosure allows the MWCNTs to become entangled with each other and easily form a conductive path, for example, by coexisting with conductive materials such as a positive electrode active material and a negative electrode active material in the electrode, the conductivity of the conductive materials can be further improved.

The MWCNT assembly according to the present disclosure can also be used together with known conductive auxiliary agents, such as graphite and Ketjen black.

The MWCNT assembly according to the present disclosure can be used as, for example, a conductive material. Examples of conductive materials to which the MWCNT assembly according to the present disclosure is applied include electrode materials in secondary batteries (for example, lithium-ion batteries), specifically negative electrode materials and positive electrode materials.

[Method for producing multi-walled carbon nanotubes]

The method for producing MWCNTs contained in the MWCNT assembly according to the present disclosure (so-called, the MWCNTs in the present disclosure) is not particularly limited.

As the method for producing the MWCNTs in the present disclosure, conventional known methods, such as a chemical vapor deposition (CVD) method and a method for reacting gaseous reactants containing a carbon source in the presence of a catalyst, can be applied.

The MWCNTs in the present disclosure can be produced with reference to the production method described in Japanese Patent Laid-Open No. 2016-102047, for example.

Hereinafter, an example of the method for producing the MWCNTs in the present disclosure will be described. However, the method for producing the MWCNTs in the present disclosure is not limited to the following example.

An example of the method for producing the MWCNTs in the present disclosure is the production method described in Japanese Patent Laid-Open No. 2016-102047, that is, a production method including the steps of: passing one or more gaseous reactants containing a carbon source through a reactor; reacting the one or more gaseous reactants in a reaction zone of the reactor in the presence of a catalyst to form product particles containing carbon; aggregating the product particles into agglomerates; and applying a force to the agglomerates to continuously move the agglomerates out of the reaction zone (also referred to as "production method X").

According to the production method X, the MWCNTs in the present disclosure can be obtained in the form of fibrous agglomerates or in other forms of agglomerates that can be handled easily.

In the production method X, the force applied to the product particles may be a mechanical force.

When the agglomerates are fibrous MWCNTs, the mechanical force applied to the product particles can be applied by a rotating spindle around which the agglomerates are wound. The fibrous MWCNTs may be collected on the spindle, or after one or more rotations around the spindle, may be accumulated at other locations as the spindle is continuously rewound.

The spindle is preferably arranged so that the spindle axis is perpendicular or parallel to the flow direction of the one or more gaseous reactants, but may also be arranged in other orientations. For example, a spindle having a spindle axis arranged at an angle of 25° relative to the flow direction of the gaseous reactants can also be suitably used to apply a mechanical force to the product particles.

The spindle can rotate around two axes (for example, two perpendicular axes). In particular, the spindle can rotate around axes that are perpendicular and parallel to the flow direction of the gaseous reactants, respectively. According to such a spindle, the fibrous MWCNT agglomerates can be drawn or twisted in order to control the twist number and length.

The material of the spindle may be made of metal, ceramic, or resin.

The spindle can take different suitable shapes depending on the characteristics of the material and the intended use of the MWCNTs. The spindle can be used as, for example, a mold for producing a carbon product by a spin coating method. A preferred shape of the spindle is a rod shape or a box shape.

The fibrous MWCNTs are accumulated on the spindle or at other locations, and the coating thickness and its orientation can be controlled by controlling the reaction time and reaction conditions, or by conditions in which an electric field or other fields are applied to the carbon product. The coating thickness and its orientation can be controlled by, for example, the flow force of the gas.

The rotational speed of the spindle is preferably 0.01 rpm (revolutions per minute; hereinafter the same) to 10000 rpm, and more preferably 0.1 rpm to 100 rpm.

The spinning speed (that is, the rotational speed of the spindle) may be adjusted so that the substance is collected at the same speed as it is produced. The rotational speed of the spindle may be used to control the thickness of the accumulated fibrous MWCNTs. In one preferred embodiment, when the spindle rotates, the fibrous MWCNTs are processed in the axial direction of the spindle. In the above processing, the fibrous MWCNTs are not wound only at a specific location on the spindle, but are wound evenly along the spindle.

The fibrous MWCNTs may be collected on the wall of the reactor by a substrate placed in the reactor, for example. The substrate may be a fixed substrate, or may be a rotating guide used to apply a strong and equal force to the fibrous MWCNTs when the fibrous MWCNTs are collected. An appropriate arrangement aspect of the substrate used in fiber technology includes a substrate composed of two guides arranged at mutually orthogonal positions.

In the production method X, the mechanical force applied to the product particles may be a force applied by an accelerated gas flow. The accelerated gas flow can be generated by passing the product particles through a reactor having a narrow diameter, or through a capillary located downstream of the reaction zone. A vacuum may also be applied to the product particles.

Other forces that may be applied to the product particles include an electrostatic force appropriately applied by a charging plate. When using the electrostatic force, it is necessary that the product particles are charged. By using a charging plate, the MWCNTs can be produced on the charging plate in a mat state in which they are entangled with each other.

Other forces that may be applied to the product particles include a magnetic force or a photon pressure applied by a light source.

Instead of the gaseous reactants containing a carbon source, the raw materials of the CNTs may be injected in the form of a liquid containing a carbon source. When using a liquid as the raw materials for the CNTs, it can be injected through a single injection port or multiple injection ports, and for example, it can be injected by using a shower head arrangement.

The one or more gaseous reactants are preferably reacted at 500°C to 1600°C, and more preferably reacted at 1000°C to 1500°C or 1600°C (in particular, 1000°C to 1500°C). It is preferable that the temperature gradient be retained in the reactor and that the reaction zone be maintained at a higher temperature than the product zone of the reactor.

The gaseous reactants may be mixed with one or more gases that act as diluents for use. The gaseous reactants may be mixed with a gas that does not play a direct role in the reaction but serves as an auxiliary. In the case where amorphous carbon, which is a byproduct, is produced, it is also preferable to use as a diluent a gas that can react with the amorphous carbon, thereby maintaining the reaction sites on the catalyst and producing nanotubes.

Examples of the gases that can be used as diluents include argon or other inert gases, hydrogen, nitrogen, ammonia, carbon dioxide, and helium. Among these, hydrogen is particularly preferable as the gas that can be used as a diluent. The gas flow rate of the diluent is preferably 2000 mL (milliliters)/min or less, and more preferably 400 mL/min to 800 mL/min.

The gas pressure of the gaseous reactants and optional diluent is preferably 0.1 bar to 50 bar, more preferably 0.5 bar to 5 bar, and still more preferably 1 bar to 2 bar. In the case where a gas flows out from the furnace, the gas flowing out can be recycled, either with or without cleaning.

The compositional features and the like of the product particles can be controlled by monitoring the agglomerates and changing the reaction conditions based on the obtained information. For example, the agglomerates can be monitored by online Raman spectroscopy. Online Raman spectroscopy can provide data indicating whether the CNTs are single-walled or multi-walled. Data indicating the diameter and crystallinity of the CNTs can also be obtained. The agglomerates can also be monitored by online conductivity measurement, gas analysis, measurement of the opacity of the reaction zone, and/or measurement of the winding force.

When removing the agglomerates from the reactor, it is preferable to prevent air from entering the reactor. In the case where the gas used as a diluent contains hydrogen, preventing the inflow of air is particularly important from the viewpoint of, for example, suppressing the formation of an explosive mixture of hydrogen and air in the reactor.

The product particles in the production method X include the MWCNTs in the present disclosure. In addition, depending on the production conditions, the product particles may include, in addition to the MWCNTs in the present disclosure, MWCNTs other than the MWCNTs in the present disclosure and/or SWCNTs.

The product particles may be produced by a chemical vapor deposition method. When the product particles are produced by a chemical vapor deposition method, the carbon source, which is a gaseous reactant, reacts in the presence of a catalyst.

Examples of carbon-containing compounds appropriate as the carbon source include carbon monoxide, carbon dioxide, aromatic hydrocarbons (for example, benzene, toluene, xylene, cumene, ethylbenzene, naphthalene, or mesitylene), non-aromatic hydrocarbons (for example, methane, ethane, propane, butane, pentane, hexane, cyclohexane, ethylene, propylene, or acetylene), and oxygen-containing hydrocarbons (for example, formaldehyde, acetaldehyde, acetone, methanol, ethanol, diethyl ether, polyethylene glycol, 1-propanol, ethyl formate, and hydrocarbons including mixtures of two or more of these).

As the carbon-containing compound, carbon monoxide, methane, ethylene, or acetylene is preferable.

It is preferable that the carbon source contain oxygen. Ethanol is a particularly preferred carbon source.

Oxygen can be introduced into the reactor by other methods, for example, by a method in which a diluent gas or a water-containing carbon source is used.

The gaseous reactant that serve as the carbon source is preferably injected into the reactor at a rate of 0.01 mL/min to 10 mL/min, and more preferably injected at a rate of 0.08 mL/min to 0.25 mL/min.

As the catalyst, the group of transition metals, in particular Group VIB chromium (Cr), molybdenum (Mo), tungsten (W), or Group VIIIB transition metals are preferable. Specifically, as the catalyst, for example, iron (Fe), cobalt (Co), nickel (Ni), ruthenium (Ru), rhodium (Rh), palladium (Pd), osmium (Os), iridium (Ir), and platinum (Pt) or manganese (Mn), or mixtures thereof, are preferable. Metals from the lanthanoid and actinoid series (for example, yttrium (Y)) can also be used as the catalyst. Fe, Ni, Co, Mo, and mixtures thereof, for example, a mixture of Ni and Co (mass ratio: 50/50), a mixture of Fe and Ni, or a mixture of Fe and Mo, are more preferable.

Any of these transition metals can be used alone or in combination with any of the other listed transition metals, and can function as a catalyst for the growth of CNTs. The catalyst is particularly preferably a mixture of two or more of the listed metals.

It is preferable that the catalyst be formed by decomposition of a precursor. The precursor is preferably a thermolytic, photolytic, or plasma-decomposable compound of one or more of the above metals, for example, a carbonyl or cyclopentadienyl organometallic compound. As the precursor, ferrocene, iron pentacarbonyl, nickelocene, and cobaltocene are particularly preferable. Appropriately, at least 0.01% by mass of the precursor is contained in the carbon source, and 0.2% by mass to 2.5% by mass of the precursor is preferably contained in the carbon source. In an aspect, 0.23% by mass to 2.3% by mass of the precursor is contained in the carbon source.

The catalyst may be supported on a carrier for use. Examples of preferred carriers include silica and magnesium oxide.

It is preferable that the carbon source be reacted in the presence of a promoter. An appropriate promoter is one or more of sulfur, phosphorus, molybdenum, and organic compounds of these elements. Thiophene is also one of the preferred promoters. Appropriately, up to 10% by mass (10% by mass or less) of the promoter is contained in the carbon source. It is preferable that 0.2% by mass to 6% by mass of the promoter be contained in the carbon source. When thiophene of a high concentration or a low concentration is used as the promoter, MWCNTs are formed.

For example, when ethanol containing 0% by mass or 1.5% by mass to 4.0% by mass of thiophene and 1.0% by mass to 10.0% by mass (in particular, 2.3% by mass) of ferrocene is used, under the conditions of an injection rate of 5.0 mL/hour to 30.0 mL/hour (in particular, 7.5 mL/hour), a hydrogen flow rate of 400 mL/min to 800 mL/min, and a synthesis temperature of 1100°C to 1180°C, MWCNTs are well formed.

According to the production method X, fibrous CNTs having a length of at least 500 μm, for example, at least 1 mm, can be obtained.

The fibrous CNTs can take a form such as a thread-like (so-called fibrous) form or a sheet-like form.

The length of the fibrous CNTs can be controlled, for example, by the winding capacity of the spindle used in producing the fibrous CNTs.

It is preferable that the production method X include the steps of: producing CNTs by reacting the carbon source in the reaction zone of the reactor; and applying a force to the CNTs, thereby aggregating the CNTs into agglomerates. According to this production method, fibrous CNTs can be easily produced.

As another aspect, a means may be taken that includes producing MWCNTs in the reaction zone by the method described above, then condensing them to form agglomerates of the MWCNTs, and continuously drawing the MWCNTs from near the reaction zone.

Also, as another aspect, a means may be taken that includes producing MWCNTs in the reaction zone, continuously electrostatically attracting the MWCNTs from the reaction zone, and collecting the MWCNTs.

[Multi-walled carbon nanotube dispersion liquid]

The MWCNT dispersion liquid according to the present disclosure comprises the MWCNT assembly according to the present disclosure described above, and a dispersion medium.

Since the MWCNT assembly according to the present disclosure has excellent dispersibility in dispersion media such as water, it can be suitably used in a dispersion liquid state.

<Multi-walled carbon nanotube assembly>

The MWCNT dispersion liquid according to the present disclosure comprises the MWCNT assembly according to the present disclosure.

Since the details of the MWCNT assembly according to the present disclosure have been described above, the description is omitted here.

The content of the MWCNT assembly according to the present disclosure in the MWCNT dispersion liquid according to the present disclosure is not particularly limited, and can be set as appropriate depending on the purpose.

For example, from the viewpoint of conductive effect, the content of the MWCNT assembly according to the present disclosure in the MWCNT dispersion liquid according to the present disclosure is preferably 0.01% by mass or more, more preferably 0.05% by mass or more, still more preferably 0.1% by mass or more, and particularly preferably 0.2% by mass or more with respect to the total mass of the MWCNT dispersion liquid.

Also, from the viewpoint of dispersibility, the content of the MWCNT assembly according to the present disclosure in the MWCNT dispersion liquid according to the present disclosure is, for example, preferably 20% by mass or less, more preferably 15% by mass or less, still more preferably 10% by mass or less, and particularly preferably 5% by mass or less with respect to the total mass of the MWCNT dispersion liquid.

In an aspect, the content of the MWCNT assembly according to the present disclosure in the MWCNT dispersion liquid according to the present disclosure may be 0.01% by mass to 20% by mass, may be 0.05% by mass to 15% by mass, may be 0.1% by mass to 10% by mass, or may be 0.2% by mass to 5% by mass with respect to the total mass of the MWCNT dispersion liquid.

<Dispersion medium>

The MWCNT dispersion liquid according to the present disclosure comprises a dispersion medium.

The dispersion medium preferably contains water, and more preferably contains water as the main component.

The term "contains water as the main component" means that the proportion of water in the dispersion medium is more than 50% by mass. The proportion of water in the dispersion medium is preferably 90% by mass or more, more preferably 95% by mass or more, and still more preferably 99% by mass or more. For example, it may be 100% by mass.

The water is not particularly limited, but for example, in terms of having few impurities, it is preferably distilled water, ion exchanged water, pure water, or the like.

The dispersion medium may be a mixed solution of water and a hydrophilic solvent.

Examples of the hydrophilic solvent include carbonate compounds such as ethylene carbonate, propylene carbonate, dimethyl carbonate, diethyl carbonate, methyl ethyl carbonate, and butylene carbonate; ether compounds such as tetrahydrofuran; ketone compounds such as acetone; lower alcohol compounds such as methanol and ethanol; and solvents such as acetonitrile.

When the dispersion medium contains a hydrophilic solvent, the proportion of the hydrophilic solvent in the dispersion medium is preferably 10% by mass or less, more preferably 5% by mass or less, and still more preferably 1% by mass or less.

<Dispersant>

The MWCNT dispersion liquid according to the present disclosure may comprise a dispersant.

When the MWCNT dispersion liquid according to the present disclosure comprises a dispersant, the dispersibility and dispersion stability of the MWCNT assembly according to the present disclosure can be improved.

The dispersant is not particularly limited, and examples thereof include various surfactants. Examples of the dispersant also include polymer compounds such as resins.

As the dispersant, a surfactant is preferable.

The surfactant may be an ionic surfactant or may be a non-ionic surfactant, and is not particularly limited.

Examples of the ionic surfactant include an anionic surfactant, a cationic surfactant, and an amphoteric surfactant.

Examples of the anionic surfactant include aromatic sulfonic acid surfactants such as alkylbenzene sulfonates (for example, dodecylbenzenesulfonic acid) and dodecyl phenyl ether sulfonates; ether sulfate surfactants; phosphate surfactants; and carboxylic acid surfactants.

Examples of the cationic surfactant include alkylamine salts and quaternary ammonium salts.

Examples of the amphoteric surfactant include alkyl betaine surfactants and amine oxide surfactants.

As the ionic surfactant, ionic surfactants having an aromatic ring (so-called aromatic ionic surfactants) are preferable, and aromatic sulfonic acid surfactants such as alkylbenzene sulfonates and dodecyl phenyl ether sulfonates are more preferable.

Aromatic ionic surfactants tend to be excellent in dispersibility, dispersion stability, and high-concentration capability of the MWCNT assembly.

Examples of the non-ionic surfactant include sugar ester surfactants such as sorbitan fatty acid esters and polyoxyethylene sorbitan fatty acid esters; fatty acid ester surfactants such as polyoxyethylene resin acid esters and polyoxyethylene fatty acid diethyl; ether surfactants such as polyoxyethylene alkyl ethers, polyoxyethylene alkyl phenyl ethers, and polyoxyethylene-polypropylene glycols; and aromatic non-ionic surfactants such as polyoxyalkylene octyl phenyl ethers, polyoxyalkylene nonyl phenyl ethers, polyoxyalkyl dibutyl phenyl ethers, polyoxyalkyl styryl phenyl ethers, polyoxyalkyl benzyl phenyl ethers, polyoxyalkyl bisphenyl ethers, polyoxyalkyl cumyl phenyl ethers, and polyoxyalkylene phenyl ethers.

As the non-ionic surfactant, ionic surfactants having an aromatic ring (so-called aromatic non-ionic surfactants) are preferable, polyoxyalkylene phenyl ethers are more preferable, and polyoxyethylene phenyl ether is still more preferable.

Aromatic non-ionic surfactants tend to be excellent in dispersibility, dispersion stability, and high-concentration capability of the MWCNT assembly.

Examples of other dispersants that are excellent in dispersibility, dispersion stability, and high-concentration capability of the MWCNT assembly include Demol N, Demol RN, and Demol T, which are sodium salts of β-naphthalenesulfonic acid-formalin condensates [manufactured by Kao Corporation], Brij S 100, which is polyoxyethylene stearyl ether [manufactured by Sigma-Aldrich], polyvinylpyrrolidone K30 [for example, manufactured by FUJIFILM Wako Pure Chemical Corporation], carboxymethyl cellulose (CMC) [for example, manufactured by Daicel Miraizu Ltd.], sodium deoxycholate [for example, manufactured by FUJIFILM Wako Pure Chemical Corporation], and SOLSPERSE(TM) W100 and SOLSPERSE(TM) W150 [manufactured by Lubrizol Japan Ltd.]. From the viewpoint of being excellent in dispersibility, dispersion stability, and high-concentration capability of the MWCNT assembly, CMC is particularly preferable.

When the MWCNT dispersion liquid according to the present disclosure comprises a dispersant, it may comprise only one type of dispersant, or may comprise two or more types thereof.

When the MWCNT dispersion liquid according to the present disclosure comprises a dispersant, the content of the dispersant in the MWCNT dispersion liquid is not particularly limited, and can be set as appropriate depending on the type of dispersant, the amount of MWCNT assembly, the amount of dispersion medium, and the like.

As an example of the content of the dispersant in the MWCNT dispersion liquid according to the present disclosure, 0.01% by mass to 20% by mass with respect to the total mass of the MWCNT dispersion liquid can be mentioned.

<Other components>

The MWCNT dispersion liquid according to the present disclosure may comprise components other than the MWCNT assembly according to the present disclosure and the dispersion medium (so-called other components) to the extent that the effects thereof are not impaired. Examples of the other components include various additives such as a defoaming agent and an antistatic agent. Also, as the other components, CNTs other than the MWCNTs in the present disclosure and carbon materials other than CNTs can be mentioned. In addition, the MWCNT dispersion liquid according to the present disclosure may comprise trace amounts of impurity components (for example, unavoidable impurities) to the extent that the effects thereof are not impaired.

<<Applications of multi-walled carbon nanotube dispersion liquid>>

The applications of the MWCNT dispersion liquid according to the present disclosure are not particularly limited.

The MWCNT dispersion liquid according to the present disclosure has excellent dispersibility of the MWCNT assembly and also has high conductivity, and therefore, it can be applied to conductive materials such as conductive inks, antistatic agents, conductive materials for circuit pattern formation, materials for transparent electrodes, and fillers for water soluble polymers.

The MWCNT dispersion liquid according to the present disclosure can be suitably used as, for example, a conductive ink for forming electrodes (in particular, negative electrodes) of various secondary batteries such as lithium-ion batteries.

By using the MWCNT dispersion liquid according to the present disclosure as a conductive ink, an electrode having high conductivity can be easily produced.

[Method for producing multi-walled carbon nanotube dispersion liquid]

The method for producing the MWCNT dispersion liquid according to the present disclosure is not particularly limited.

The MWCNT dispersion liquid according to the present disclosure can be produced by dispersing the MWCNT assembly according to the present disclosure in a dispersion medium. That is, the MWCNT dispersion liquid according to the present disclosure can be produced by a method including a step of dispersing the MWCNT assembly according to the present disclosure in a dispersion medium (also referred to as "dispersion step").

<Dispersion step>

The dispersion step is a step of dispersing the MWCNT assembly according to the present disclosure in a dispersion medium. In the dispersion step, from the viewpoint of improvement in the dispersibility and dispersion stability of the MWCNT assembly according to the present disclosure, a dispersant may be used.

The details of the MWCNT assembly according to the present disclosure, the dispersion medium, and the dispersant are as described above, and therefore, description thereof is omitted here.

The dispersion method is not particularly limited.

Examples of the dispersion method include a method using a dispersion apparatus such as a stirrer, a homogenizer, a colloid mill, a flow jet mixer, a dissolver, a paint conditioner, a Manton emulsifying apparatus, a jet mill, or an ultrasonic apparatus (for example, ultrasonic dispersing machine).

Examples of the dispersion method also include a method using a known pulverization means, such as a dispersing machine including ball milling (for example, ball mill, vibrating ball mill, planetary ball mill, bead mill, and the like), sand milling, colloid milling, jet milling, roller milling, a vertical or horizontal agitator mill, an attritor, a colloid mill, a three-roll mill, a pearl mill, a super mill, an impeller, a disperser, a KD mill, Dynatron, or a pressure kneader.

As the dispersion method, a method using a jet mill is preferable, and a method using a wet jet mill is more preferable.

A wet jet mill is a dispersion apparatus in which a mixture in a solvent is pressurized and discharged from a nozzle arranged in a sealed state in a pressure-resistant container as a high speed flow. In the wet jet mill, the multi-walled carbon nanotube assembly is dispersed by collisions between opposing flows in the pressure-resistant container, collisions with the container walls, turbulence and shear flow generated by the high-speed flow, and the like. As the wet jet mill, an ultra high pressure homogenizer manufactured by Jokoh Co., Ltd. (model number: NAGS20, NAGS100, NAGS200, NAGS1000, or the like) can be suitably used. However, the wet jet mill is not limited thereto.

When the above ultra-high pressure homogenizer is used as the dispersion apparatus, the processing pressure for dispersion is preferably 10 MPa to 250 MPa.

<Drying step>

The method for producing the MWCNT dispersion liquid according to the present disclosure may include, prior to the dispersion step described above, a step of drying the MWCNT assembly according to the present disclosure (also referred to as "drying step").

When moisture adheres to the MWCNTs, the MWCNTs tend to stick together due to the surface tension of water. By performing the drying step before the dispersion step, the moisture adhering to the MWCNTs is removed, and sticking of the MWCNTs due to adhesion of the moisture is suppressed, thereby further improving the dispersibility of the MWCNT assembly.

The drying method is not particularly limited.

Examples of the drying method include heating drying, vacuum drying, and heating vacuum drying.

As the drying method, heating vacuum drying is preferable.

The drying temperature is not particularly limited, and for example, it is preferably 40°C to 100°C.

The drying time is not particularly limited, and can be set as appropriate depending on the drying temperature, the degree of moisture adhering to the MWCNTs, and the like.

The MWCNT dispersion liquid according to the present disclosure can be suitably produced by the method described in the Examples, which will be described later, for example.

[Conductive material]

The conductive material according to the present disclosure comprises the MWCNT assembly according to the present disclosure.

As described above, the MWCNT assembly according to the present disclosure contained in the conductive material according to the present disclosure has high conductivity and excellent dispersibility when formed into a dispersion liquid, and therefore, it is suitable as a conductive auxiliary agent. Since the conductive material according to the present disclosure comprises the MWCNT assembly according to the present disclosure, it is excellent in conductive efficiency and can effectively impart high conductivity to the object to be used.

The conductive material according to the present disclosure may comprise a known conductive auxiliary agent such as graphite or Ketjen black. In addition, the conductive material according to the present disclosure may comprise CNTs other than the MWCNT assembly according to the present disclosure.

The conductive material according to the present disclosure can be used as one of electrode materials. An example of an electrode formed using the electrode material is an electrode provided in a secondary battery. Hereinafter, one embodiment of an electrode and a secondary battery provided with the electrode will be described.

<Electrode>

The electrode can contain the MWCNT assembly according to the present disclosure described above.

In the electrode, the MWCNT assembly according to the present disclosure can function as a conductive auxiliary agent.

The MWCNT assembly contained in the electrode described below is synonymous with the MWCNT assembly according to the present disclosure and its preferred aspects are also the same; therefore, the description of the MWCNT assembly will be omitted below.

The electrode may be at least one of a positive electrode and a negative electrode.

The electrode may contain an electrode active material layer, or may contain a current collector and an electrode active material layer arranged on the current collector.

The current collector is not particularly limited as long as it does not induce chemical changes in the battery and has conductivity.

Examples of the current collector include copper, stainless steel, aluminum, nickel, titanium, baked carbon, and aluminum or stainless steel whose surface has been surface-treated with carbon, nickel, titanium, silver, or the like. Specifically, a transition metal having good carbon adsorbability, such as copper or nickel, may be used as the current collector.

The electrode active material layer can contain an electrode active material.

The electrode active material is preferably electrode active material particles.

When the electrode is a positive electrode, the electrode active material is not particularly limited, and the electrode active material layer can contain a positive electrode active material usually used in electrode materials for positive electrodes.

Specific examples of the positive electrode active material include layered compounds such as lithium cobalt oxide ($LiCoO_2$) and lithium nickel oxide ($LiNiO_2$), compounds substituted with one or two or more transition metals; lithium iron oxides such as $LiFe_3O_4$; lithium manganese oxides such as the chemical formulae $Li_{1+c1}Mn_{2-c1}O_4$ ($0 \leq c1 \leq 0.33$), $LiMnO_3$, $LiMn_2O_3$, and $LiMnO_2$; lithium copper oxide ($Li_2CuO_2$); vanadium oxides such as $LiV_3O_8$, $V_2O_5$, and $Cu_2V_2O_7$; Ni site-type lithium nickel oxides represented by the chemical formula $LiNi_{1-c2}M_{c2}O_2$ (where M is at least one selected from the group consisting of Co, Mn, Al, Cu, Fe, Mg, B, and Ga, and $0.01 \leq c2 \leq 0.66$ is satisfied); lithium manganese composite oxides represented by the chemical formula $LiMn_{2-c3}M_{c3}O_2$ (where M is at least one selected from the group consisting of Co, Ni, Fe, Cr, Zn, and Ta, $0.01 \leq c3 \leq 0.1$ is satisfied) or $Li_2Mn_3MO_8$ (where M is at least one selected from the group consisting of Fe, Co, Ni, Cu, and Zn); and $LiMn_2O_4$ in which a portion of Li in the chemical formula is replaced with an alkaline earth metal ion.

When the electrode is a negative electrode, the electrode active material is not particularly limited, and the electrode active material layer can contain a negative electrode active material usually used in electrode materials for negative electrodes.

Specifically, the negative electrode active material can contain graphite-based active material particles or silicon-based active material particles.

As the graphite-based active material particles, at least one selected from the group consisting of artificial graphite, natural graphite, graphitized carbon fibers, and graphitized mesocarbon microbeads may be used. By using artificial graphite as the graphite-based active material particles, the rate characteristics can be improved.

As the silicon-based active material particles, at least one selected from the group consisting of Si, SiOx (0 < x < 2), Si-C composites, and Si-Y alloys (where Y is an element selected from the group consisting of alkali metals, alkaline earth metals, transition metals, Group 13 elements, Group 14 elements, rare earth elements, and combinations thereof) may be used. By using the silicon-based active material particles, the battery can be made to have a higher capacity.

The electrode active material layer can further contain a binder.

The binder is not particularly limited, and the electrode active material layer can contain a binder usually used in electrode materials.

Examples of the binder include at least one polymer selected from the group consisting of polyvinylidene fluoride-hexafluoropropylene copolymer (PVDF-co-HFP), polyvinylidene fluoride, polyacrylonitrile, polymethyl methacrylate, polyvinyl alcohol, carboxymethyl cellulose (CMC), starch, hydroxypropyl cellulose, regenerated cellulose, polyvinylpyrrolidone, tetrafluoroethylene, polyethylene, polypropylene, ethylenepropylene-diene monomer (EPDM), sulfonated EPDM, styrene-butadiene rubber (SBR), fluororubber, and polyacrylic acid, as well as polymers in which hydrogen atoms possessed by these polymers are replaced with Li, Na, Ca, or the like.

<Secondary battery>

The secondary battery may be configured to include a negative electrode, a positive electrode, a separator interposed between the positive electrode and the negative electrode, and an electrolyte. At least one of the positive electrode and the negative electrode is an electrode formed using an electrode material containing the MWCNT assembly according to the present disclosure.

The separator separates the negative electrode and the positive electrode and provides a migration pathway for lithium ions. The separator is not particularly limited as long as it is usually used as a separator in secondary batteries. It is preferable that the separator be low in resistance to ion migration of the electrolyte and excellent in electrolytic solution retention capability.

Specific examples of the separator include a porous polymer film.

The porous polymer film may be, for example, a porous polymer film produced from a polyolefin-based polymer such as an ethylene homopolymer, a propylene homopolymer, an ethylene/butene copolymer, an ethylene/hexene copolymer, or an ethylene/methacrylate copolymer, or a laminated structure in which two or more of these films are stacked.

The separator may also be a usual porous non-woven fabric, for example, a non-woven fabric composed of high melting point glass fibers, polyethylene terephthalate fibers, or the like. The separator may also be one coated with a ceramic component or a polymeric material in order to ensure heat resistance or mechanical strength.

The separator can selectively have a single-layer structure or a multilayer structure.

The electrolyte is not particularly limited, and examples thereof include electrolytes such as organic liquid electrolytes, inorganic liquid electrolytes, solid polymer electrolytes, gel-type polymer electrolytes, solid inorganic electrolytes, and molten inorganic electrolytes that can be used at the time of production of lithium secondary batteries.

Specifically, the electrolyte can contain a non-aqueous organic solvent and a metal salt.

Examples of the non-aqueous organic solvent include non-protonic organic solvents such as N-methyl-2-pyrrolidone, propylene carbonate, ethylene carbonate, butylene carbonate, dimethyl carbonate, diethyl carbonate, $\gamma$-butyrolactone, 1,2-dimethoxyethane, tetrahydroxyfuran, 2-methyltetrahydrofuran, dimethyl sulfoxide, 1,3-dioxolane, formamide, dimethylformamide, dioxolane, acetonitrile, nitromethane, methyl formate, methyl acetate, trialkyl phosphates, trimethoxymethane, dioxolane derivatives, sulfolane, methylsulfolane, 1,3-dimethyl-2-imidazolidinone, propylene carbonate derivatives, tetrahydrofuran derivatives, ethers, methyl propionate, and ethyl propionate.

Among carbonate-based organic solvents, ethylene carbonate and propylene carbonate, which are cyclic carbonates, have high dielectric constants as high viscosity organic solvents and dissociate lithium salts well, and therefore are preferably used as non-aqueous organic solvents. Using, as the non-aqueous organic solvent, a mixture obtained by mixing such cyclic carbonates with linear carbonates having low viscosity and low dielectric constants, such as dimethyl carbonate and diethyl carbonate, in appropriate proportions is more preferable in that an electrolyte having high electrical conductivity can be obtained.

The metal salt may be a lithium salt.

The lithium salt is a substance that is easily dissolved in a non-aqueous electrolytic solution.

Examples of the anion portion of the lithium salt include $F^-$, $Cl^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$.

In addition to the non-aqueous organic solvent and the metal salt, for purposes such as improving battery life characteristics, suppressing battery capacity reduction, and enhancing battery discharge capacity, the electrolyte may further contain one or more additives such as haloalkylene carbonate compounds including difluoroethylene carbonate, pyridine, triethyl phosphite, triethanolamine, cyclic ethers, ethylenediamine, n-glyme, hexaphosphoric triamide, nitrobenzene derivatives, sulfur, quinone imine dyes, N-substituted oxazolidinone, N,N-substituted imidazolidine, ethylene glycol dialkyl ethers, ammonium salts, pyrrole, 2-methoxyethanol, and aluminum trichloride.

The secondary battery described above can constitute a battery module including the secondary battery as a unit cell, and a battery pack including the battery module.

The battery module and the battery pack can be used as, for example, a power source for medium- to large-sized devices selected from the group consisting of electric vehicles, hybrid electric vehicles, plug-in hybrid electric vehicles, and power storage systems.

[Composition]

<Resin, ceramic, concrete, and the like>

The composition according to the present disclosure is a composition comprising the MWCNT assemblies (A) to (E) according to the present disclosure, and at least one selected from the group consisting of resin, ceramic, and concrete.

Examples of the resin include thermoplastic resins and thermosetting resins, with olefin-based resins, polycarbonate-based resins, polyester-based resins, polyamide-based resins, thermoplastic polyurethane resins, polysulfone-based resins, and silicone resins being preferable.

Examples of the ceramic include crystalline ceramics and non-crystalline ceramics.

Examples of the concrete include Portland cement concrete.

The composition according to the present disclosure may further comprise other components such as water and organic solvents.

In the composition according to the present disclosure, when the content of the MWCNT assemblies (A) to (E) according to the present disclosure is set to 100 parts by mass, the content of the at least one selected from the group consisting of resin, ceramic, and concrete is usually 10 to 1000000 parts by mass, preferably 100 to 100000 parts by mass, more preferably 1000 to 40000 parts by mass, and when other components are contained, preferably 1 to 10000 parts by mass, more preferably 10 to 1000 parts by mass.

In the composition according to the present disclosure, the MWCNT assemblies (A) to (E), the resin, the ceramic, the concrete, and the other components may each be contained alone as a single type or may be contained as two or more types.

<Method for producing composition>

The composition according to the present disclosure can be produced by, for example, kneading the MWCNT assemblies (A) to (E) according to the present disclosure into resin, ceramic, or uncured concrete. The resin may be in the form of a powder, pellets, a solution, or a dispersion liquid. The ceramic may be in the form of a powder, a precursor solution, or a dispersion liquid.

The composition according to the present disclosure can also be produced by, for example, molding after dispersing the MWCNT assemblies (A) to (E) according to the present disclosure into a resin solution, a ceramic precursor or dispersion liquid, or uncured concrete.

<Applications of composition>

When the composition according to the present disclosure comprises resin or ceramic, it is useful as a structural material, a conductive material, a thermal management material, or an antistatic material, for example.

When the composition according to the present disclosure comprises concrete, it is useful as a building material with improved lightweight and durability, or as an energy storage device (if necessary, impregnated with an electrolyte).

[Planar assembly]

The planar assembly according to the present disclosure comprises the MWCNT assembly according to the present disclosure.

The proportion of the MWCNT assembly according to the present disclosure contained in the planar assembly according to the present disclosure is usually 1% by mass or more with respect to the total mass of the planar assembly.

The planar assembly according to the present disclosure may comprise other components such as a CNT assembly (in particular, MWCNT assembly) having a maximum length of less than 1000 μm.

[Method for producing planar assembly]

The method for producing the planar assembly according to the present disclosure is not particularly limited.

The planar assembly according to the present disclosure can be produced as, for example, a non-woven fabric-like planar assembly by dispersing the MWCNT assembly according to the present disclosure, or the MWCNT assembly according to the present disclosure and other components such as a CNT assembly (in particular, MWCNT assembly) having a maximum length of less than 1000 $\mu$m, in water or other fluids, and filtering once or two or more times.

Examples of the planar assembly according to the present disclosure include a film.

The planar assembly according to the present disclosure is useful as, for example, a filter, an electromagnetic wave shielding, and a pellicle for extreme ultraviolet rays (EUV).

Examples

The following examples are provided to further specifically describe the MWCNT assembly according to the present disclosure. The MWCNT assembly according to the present disclosure is not limited to the following examples as long as it does not depart from the spirit of the present disclosure.

[Production of MWCNT assembly or preparation of SWCNT assembly]

<Example 1>

The MWCNT assembly 1 of Example 1 was produced by a floating catalyst method (CVD method) in which CNT bundles self-assemble and directly interact in the gas phase.

First, ferrocene as a metal catalyst precursor containing Fe atoms and thiophene as a promoter were introduced into a continuous flow of carrier gas in a through-flow reactor whose temperature was controlled at 400°C to 700°C. A mixed gas of nitrogen and argon was used as the carrier gas, and the flow rate of the carrier gas was set to 30000 sccm (standard cubic centimeters per minute).

By maintaining the temperature in the through-flow reactor within the above range, the metal catalyst precursor was produced as a particulate metal catalyst. The region in which the metal catalyst was produced is referred to as the first temperature zone.

Next, methane, which is a carbon source, was released into the carrier gas flow. The metal catalyst and the carbon source were supplied to a second temperature zone whose temperature was controlled at 1400°C, located downstream of the first temperature zone. The second temperature zone was maintained at a temperature sufficient to produce carbon nanotube aggregates.

In the second temperature zone, an electric field was generated in the temperature-controlled flow reactor, which led to the production of MWCNT aggregates.

The produced aggregates were continuously discharged through the outlet of the flow reactor whose temperature was controlled at 100°C to 500°C, and collected as a sheet-like MWCNT assembly by continuous discharge.

The collected sheet-like MWCNT assembly was immersed for 24 hours in a PTFE tray containing hydrochloric acid (manufactured by FUJIFILM Wako Pure Chemical Corporation, special grade reagent). Thereafter, the MWCNT assembly was taken out of the tray and rinsed with deionized water until the pH of the wash water reached 7.

In this manner, the MWCNT assembly 1 of Example 1 was obtained.

<Example 2>

The MWCNT assembly 2 of Example 2 was obtained in accordance with Example 1, except that the collected sheet-like MWCNT assembly in Example 1 was washed with deionized water for 10 seconds.

<Example 3>

The MWCNT assembly 3 of Example 3 was produced in the same manner as the sheet-like MWCNT assembly collected in Example 1, by a floating catalyst method (CVD method) in which CNT bundles self-assemble and directly interact in the gas phase.

First, ferrocene as a metal catalyst precursor containing Fe atoms and thiophene as a promoter were introduced into a continuous flow of carrier gas in a through-flow reactor whose temperature was controlled at 400°C to 700°C. The carrier gas used was a mixed gas of nitrogen and argon. The flow rate of the carrier gas was set to 30000 sccm.

By maintaining the temperature in the through-flow reactor within the above range, the metal catalyst precursor was produced as a particulate metal catalyst. The region in which the metal catalyst was produced is referred to as the first temperature zone.

Next, methane, which is a carbon source, was released into the carrier gas flow. The metal catalyst and the carbon source were supplied to a second temperature zone whose temperature was controlled at 1400°C, located downstream of the first temperature zone. The second temperature zone was maintained at a temperature sufficient to produce carbon nanotube aggregates.

In the second temperature zone, an electric field was generated in the temperature-controlled flow reactor, which led to the production of MWCNT aggregates.

The produced aggregates were continuously discharged through the outlet of the flow reactor whose temperature was controlled at 100°C to 500°C, and collected as a fibrous MWCNT assembly by continuous discharge.

The collected fibrous MWCNT assembly was washed with deionized water for 10 seconds.

In this manner, the MWCNT assembly 3 of Example 3 was obtained.

<Comparative Example 1>

A SWCNT assembly 1 [trade name: TUBALL(TM), single-walled carbon nanotube powder, manufactured by OCSiAl] was used as Comparative Example 1.

<Comparative Example 2>

A MWCNT assembly 4 [product number: 901019, multi-walled carbon nanotube powder, manufactured by Sigma-Aldrich] was used as Comparative Example 2.

<Comparative Example 3>

A MWCNT assembly 5 [product number: FT7000, multi-walled carbon nanotube powder, manufactured by Cnano Technology] was used as Comparative Example 3.

[Evaluation]

The following evaluations were conducted for the MWCNT assembly 1 of Example 1, the MWCNT assembly 2 of Example 2, the MWCNT assembly 3 of Example 3, the SWCNT assembly 1 of Comparative Example 1, the MWCNT assembly 4 of Comparative Example 2, and the MWCNT assembly 5 of Comparative Example 3. Hereinafter, for convenience, "the MWCNT assembly 1 of Example 1, the MWCNT assembly 2 of Example 2, the MWCNT assembly 3 of Example 3, the SWCNT assembly 1 of Comparative Example 1, the MWCNT assembly 4 of Comparative Example 2, and the MWCNT assembly 5 of Comparative Example 3" may collectively be referred to as "the CNT assemblies".

1. Observation of SEM image

(1) Preparation of CNT dispersion liquid for SEM imaging

(1-1) MWCNT assembly 1 of Example 1

1.1 g of the MWCNT assembly 1 of Example 1, 1.65 g of carboxymethyl cellulose [trade name: Carboxymethyl Cellulose Sodium Salt High Viscosity, manufactured by MP Biomedicals] as a dispersant, and 547.25 g of ion exchanged water were mixed. The obtained mixed solution was subjected to a dispersion treatment as pre-dispersion before the main dispersion for 1 hour using ACE HOMOGENIZER manufactured by NIHONSEIKI KAISHA LTD., resulting in a dispersion liquid A. In order to prevent the MWCNT assembly 1 from getting entangled with the blades of the homogenizer, the MWCNT assembly 1 was cut into small pieces of about 1 cm square using scissors before mixing.

Subsequently, the dispersion liquid A obtained as described above was subjected to the main dispersion treatment under the conditions described below using an ultra high pressure homogenizer manufactured by Jokoh Co., Ltd., which is a wet jet mill (model number: NAGS100), thereby obtaining a CNT dispersion liquid A for SEM imaging.

- Conditions -

Nozzle diameter: 0.22 mm
Pressure: 85 MPa

Number of times: 8 times
Method: Circulation method

(1-2) MWCNT assembly 2 of Example 2

1.1 g of the MWCNT assembly 2 of Example 2, 1.65 g of carboxymethyl cellulose [trade name: Carboxymethyl Cellulose Sodium Salt High Viscosity, manufactured by MP Biomedicals] as a dispersant, and 547.25 g of ion exchanged water were mixed. The obtained mixed solution was subjected to a dispersion treatment as pre-dispersion before the main dispersion for 1 hour using ACE HOMOGENIZER manufactured by NIHONSEIKI KAISHA LTD., resulting in a dispersion liquid B. In order to prevent the MWCNT assembly 2 from getting entangled with the blades of the homogenizer, the MWCNT assembly 2 was cut into small pieces of about 1 cm square using scissors before mixing.
Subsequently, the dispersion liquid B obtained as described above was subjected to the main dispersion treatment under the same conditions as the above-described main dispersion treatment in "(1-1) MWCNT assembly 1 of Example 1" using an ultra high pressure homogenizer manufactured by Jokoh Co., Ltd., which is a wet jet mill (model number: NAGS100), thereby obtaining a CNT dispersion liquid B for SEM imaging.

(1-3) MWCNT assembly 3 of Example 3

1.1 g of the MWCNT assembly 3 of Example 3, 1.65 g of carboxymethyl cellulose [trade name: Carboxymethyl Cellulose Sodium Salt High Viscosity, manufactured by MP Biomedicals] as a dispersant, and 547.25 g of ion exchanged water were mixed. The obtained mixed solution was subjected to a dispersion treatment as pre-dispersion before the main dispersion for 1 hour using ACE HOMOGENIZER manufactured by NIHONSEIKI KAISHA LTD., resulting in a dispersion liquid C. In order to prevent the MWCNT assembly 3 from getting entangled with the blades of the homogenizer, the MWCNT assembly 3 was cut to a length of about 1 cm using scissors before mixing.
Subsequently, the dispersion liquid C obtained as described above was subjected to the main dispersion treatment under the same conditions as the above-described main dispersion treatment in "(1-1) MWCNT assembly 1 of Example 1" using an ultra high pressure homogenizer manufactured by Jokoh Co., Ltd., which is a wet jet mill (model number: NAGS100), thereby obtaining a CNT dispersion liquid C for SEM imaging.

(1-4) SWCNT assembly 1 of Comparative Example 1

As the dispersion liquid of the SWCNT assembly 1 of Comparative Example 1, a CNT dispersion liquid D for SEM imaging [trade name: TUBALL(TM) BATT $H_2O$, single-walled carbon nanotube aqueous solution, manufactured by OCSiAl] was used. The CNT concentration was adjusted to 0.2% by mass.

(1-5) MWCNT assembly 4 of Comparative Example 2

1.1 g of the MWCNT assembly 4 of Comparative Example 2, 1.65 g of carboxymethyl cellulose [trade name: Carboxymethyl Cellulose Sodium Salt High Viscosity, manufactured by MP Biomedicals] as a dispersant, and 547.25 g of ion exchanged water were mixed. The obtained mixed solution was subjected to a dispersion treatment as pre-dispersion before the main dispersion for 1 hour using ACE HOMOGENIZER manufactured by NIHONSEIKI KAISHA LTD., resulting in a dispersion liquid E.
Subsequently, the dispersion liquid E obtained as described above was subjected to the main dispersion treatment under the same conditions as the above-described main dispersion treatment in "(1-1) MWCNT assembly 1 of Example 1" using an ultra high pressure homogenizer manufactured by Jokoh Co., Ltd., which is a wet jet mill (model number: NAGS100), thereby obtaining a CNT dispersion liquid E for SEM imaging.

(1-6) MWCNT assembly 5 of Comparative Example 3

1.1 g of the MWCNT assembly 5 of Comparative Example 3, 1.65 g of carboxymethyl cellulose [trade name: Carboxymethyl Cellulose Sodium Salt High Viscosity, manufactured by MP Biomedicals] as a dispersant, and 547.25 g of ion exchanged water were mixed. The obtained mixed solution was subjected to a dispersion treatment as pre-dispersion before the main dispersion for 1 hour using ACE HOMOGENIZER manufactured by NIHONSEIKI KAISHA LTD., resulting in a dispersion liquid F.
Subsequently, the dispersion liquid F obtained as described above was subjected to the main dispersion treatment under the same conditions as the above-described main dispersion treatment in "(1-1) MWCNT assembly 1 of Example 1" using an ultra high pressure homogenizer manufactured by Jokoh Co., Ltd., which is a wet jet mill (model number: NAGS100), thereby obtaining a CNT dispersion liquid F for SEM imaging.

(2) SEM imaging

(2-1) MWCNT assembly 1 of Example 1

When a SEM image (magnification: 5000x) of the MWCNT assembly 1 of Example 1 was taken, it was confirmed that multiple MWCNTs having a maximum length in the range of 500 $\mu$m to 30000 $\mu$m were present within the field of view of the SEM image.

In addition, multiple SEM images (magnification: 5000x) with adjacent fields of view of the MWCNT assembly 1 of Example 1 were taken, and focusing on 100 MWCNTs included in the field of view of the SEM images, the maximum length of each was measured. As a result, among the observed MWCNTs, the proportion of MWCNTs having a maximum length in the range of 500 $\mu$m to 30000 $\mu$m (that is, SLMWCNTs) was 90%, and the maximum value of the maximum length among the 100 observed MWCNTs was 3500 $\mu$m.

(2-2) MWCNT assembly 2 of Example 2

When a SEM image (magnification: 5000x) of the MWCNT assembly 2 of Example 2 was taken, it was confirmed that multiple MWCNTs having a maximum length in the range of 500 $\mu$m to 30000 $\mu$m were present within the field of view of the SEM image.

In addition, multiple SEM images (magnification: 5000x) with adjacent fields of view of the MWCNT assembly 2 of Example 2 were taken, and focusing on 100 MWCNTs included in the field of view of the SEM images, the maximum length of each was measured. As a result, among the observed MWCNTs, the proportion of MWCNTs having a maximum length in the range of 500 $\mu$m to 30000 $\mu$m (that is, SLMWCNTs) was 90%, and the maximum value of the maximum length among the 100 observed MWCNTs was 3500 $\mu$m.

(2-3) MWCNT assembly 3 of Example 3

When a SEM image (magnification: 5000x) of the MWCNT assembly 3 of Example 3 was taken, it was confirmed that multiple MWCNTs having a maximum length in the range of 500 $\mu$m to 30000 $\mu$m were present within the field of view of the SEM image.

In addition, multiple SEM images (magnification: 5000x) with adjacent fields of view of the MWCNT assembly 3 of Example 3 were taken, and focusing on 100 MWCNTs included in the field of view of the SEM images, the maximum length of each was measured. As a result, among the observed MWCNTs, the proportion of MWCNTs having a maximum length in the range of 500 $\mu$m to 30000 $\mu$m (that is, SLMWCNTs) was 90%, and the maximum value of the maximum length among the 100 observed MWCNTs was 4000 $\mu$m.

(2-4) CNT dispersion liquid A, CNT dispersion liquid D, and CNT dispersion liquid E

SEM images of the CNT dispersion liquid A, CNT dispersion liquid D, and CNT dispersion liquid E for SEM imaging prepared as described above were taken using a scanning electron microscope at a magnification ratio of 500x.

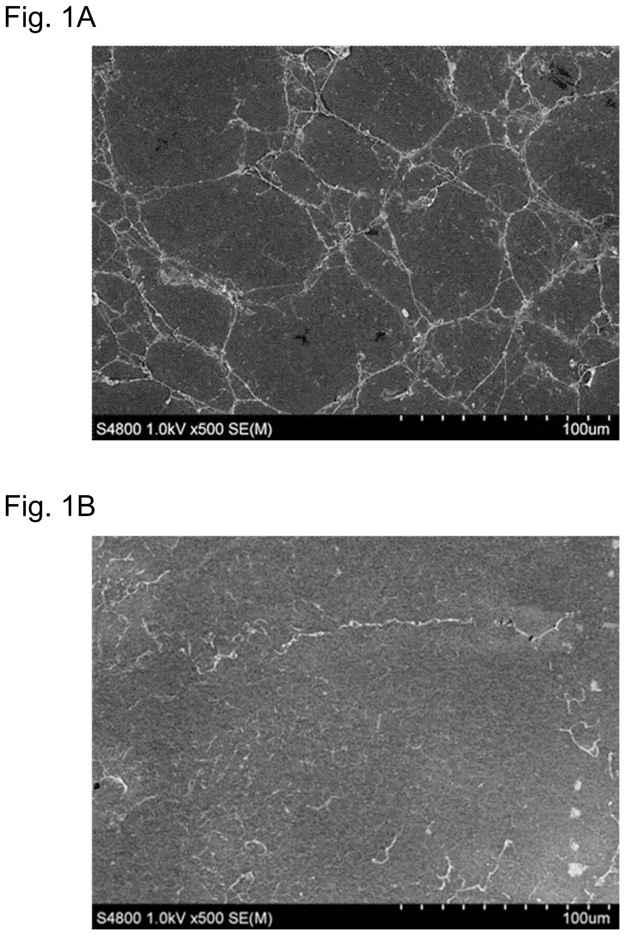

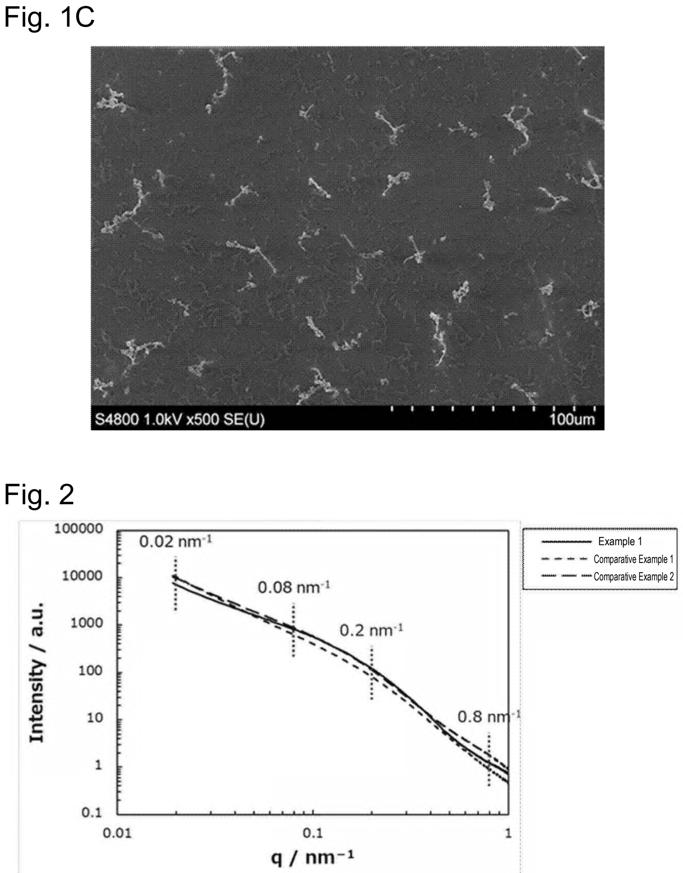

The results are shown in Figure 1A, Figure 1B, and Figure 1C.

Figure 1A is a SEM image of the CNT dispersion liquid A for SEM imaging containing the MWCNT assembly 1 of Example 1, Figure 1B is a SEM image of the CNT dispersion liquid D for SEM imaging containing the SWCNT assembly 1 of Comparative Example 1, and Figure 1C is a SEM image of the CNT dispersion liquid E for SEM imaging containing the MWCNT assembly 4 of Comparative Example 2.

As shown in Figure 1A, in the CNT dispersion liquid A for SEM imaging containing the MWCNT assembly 1 of Example 1, it was confirmed that multiple fibrous MWCNTs were entangled with each other to form an assembly. In contrast, as shown in Figure 1B and Figure 1C, in the CNT dispersion liquid D for SEM imaging containing the SWCNT assembly 1 of Comparative Example 1 and the CNT dispersion liquid E for SEM imaging containing the MWCNT assembly 4 of Comparative Example 2, almost no entanglement of CNTs was observed.

2. Median diameter

The median diameter of the CNTs contained in the CNT assembly was measured.

The CNT dispersion liquids A to F for SEM imaging obtained in "(1) Preparation of CNT dispersion liquid for SEM imaging" in "1. Observation of SEM image" above were diluted with ion exchanged water to obtain aqueous dispersion liquids A to F having a CNT concentration of 0.004% by mass.

Using the obtained aqueous dispersion liquids A to F as measurement samples and using LUMiSizer 611 (trade name), which is a centrifugal sedimentation dispersion stability particle diameter distribution apparatus manufactured by LUM GmbH, as the measurement apparatus, the volume-based particle size distribution of the CNTs was measured under the measurement conditions described below. In the measured volume-based particle size distribution, the particle diameter at which the cumulative frequency reached 50% was read and defined as the median diameter.

The results are shown in Table 1.

<Measurement conditions>

Measurement cell: Polycarbonate cell (optical path length: 2 mm)
Rotation speed: 4000 rpm
Centrifugal acceleration: 2300 × g
Measurement interval: 30 seconds
Number of measurements: 1000 times
Measurement temperature: 25°C

3. Rate of change in transmittance

The rate of change in transmittance of the CNTs contained in the CNT assembly was measured.

The CNT dispersion liquids A to F for SEM imaging (CNT concentration: 0.2% by mass) obtained in "(1) Preparation of CNT dispersion liquid for SEM imaging" in "1. Observation of SEM image" above were used as measurement samples and using LUMiSizer 611 (trade name), which is a centrifugal sedimentation dispersion stability particle diameter distribution apparatus manufactured by LUM GmbH, as the measurement apparatus, sedimentation profiles were obtained under the measurement and analysis conditions described below. By analyzing the rate of change in overall transmittance from the obtained sedimentation profile, the rate of change in transmittance was determined.

The results are shown in Table 1.

<Measurement and analysis conditions>

Measurement cell: Polycarbonate cell (optical path length: 2 mm)
Rotation speed: 4000 rpm
Centrifugal acceleration: 2300 × g
Measurement interval: 30 seconds
Number of measurements: 1000 times
Viscosity of dispersion medium: 0.8946 mPa·s
Density of dispersion medium: 997.3 kg/m$^3$
Density of dispersoid: 1350 kg/m$^3$
Refractive index of dispersion medium (real part): 1.326
Refractive index of dispersoid (real part): 1.630
Refractive index of dispersion medium (imaginary part): 0.5153

In the analysis conditions described above, the dispersion medium is water and the dispersoid is the CNTs.

The values of the viscosity, density, and refractive index described above are all values at 25°C.

4. Scattering intensity ratio S1/S2 and scattering intensity ratio S3/S4

The scattering intensity ratio S1/S2 and the scattering intensity ratio S3/S4 of the CNTs contained in the CNT assembly were measured.

The CNT dispersion liquids A to F for SEM imaging (CNT concentration: 0.2% by mass) obtained in "(1) Preparation of CNT dispersion liquid for SEM imaging" in "1. Observation of SEM image" above were used as measurement samples.

The measurement sample was filled into a NMR tube with an outer diameter of 2.99 ± 0.03 mm and an inner diameter of 2.41 ± 0.03 mm (trade name: S-3-HT-7, manufactured by NORELL, Inc.) without introducing bubbles, and a scattering profile of the CNTs was then obtained using the BL03XU beamline of SPring-8, which is a large synchrotron radiation facility, as the small-angle X-ray scattering experimental facility.

The measurement by the small-angle X-ray scattering method was performed in accordance with the description in "Structural Science of Crystalline Polymers, Kohji Tashiro, Springer, 2022". More specifically, the measurement was performed under the conditions of an X-ray wavelength of 0.1 nm, a beam diameter of 100 $\mu$m, and a camera length of 8000 mm, using PILATUS 1M manufactured by Dectris Ltd. as the detector, in an environment with an ambient temperature of 25°C. During the measurement, no attenuator was used, and X-rays were incident in a direction perpendicular to the length direction near the axis center of the NMR tube. The irradiation position was shifted by 100 $\mu$m along the length direction with an exposure time of 1 second, and 10 measurements were performed to obtain a total two-dimensional scattering image Ms. At the same time as capturing the two-dimensional scattering image, a transmitted light intensity fs was measured at an ion chamber downstream of the NMR tube. Under the same conditions as described above except that ion exchanged water was filled in the NMR tube instead of the aqueous dispersion liquid, a background two-dimensional scattering image Mb and a transmitted light intensity fb were measured.

According to the following expression (1), a background-corrected two-dimensional scattering image M was obtained. At this time, the range where scattered X-rays were blocked by a beam stopper or the like provided to prevent the direct beam from entering the detector was excluded from the two-dimensional scattering image M.

$$M = Ms/fs - Mb/fb \qquad (1)$$

A one-dimensional profile in the radial direction was obtained from the two-dimensional scattering image M by annular averaging. Note that the horizontal axis was calibrated to the scattering vector magnitude q using collagen as a standard substance.

From the obtained one-dimensional profile, the scattering intensity S1 at a scattering vector magnitude q = 0.2 nm$^{-1}$, the scattering intensity S2 at a scattering vector magnitude q = 0.8 nm$^{-1}$, the scattering intensity S3 at a scattering vector magnitude q = 0.02 nm$^{-1}$, and the scattering intensity S4 at a scattering vector magnitude q = 0.08 nm$^{-1}$ were read, and the scattering intensity ratio S1/S2 and the scattering intensity ratio S3/S4 were determined.

The results are shown in Table 2. In addition, the scattering profile of each CNT assembly obtained by the small-angle X-ray scattering method is shown in Figure 2.

5. Conductivity

The CNT dispersion liquids A to F for SEM imaging (CNT concentration: 0.2% by mass) obtained in "(1) Preparation of CNT dispersion liquid for SEM imaging" in "1. Observation of SEM image" above were dropped onto a glass substrate cut to a size of 10 cm × 10 cm, and film formation was performed using a stainless steel applicator with a gap size of 150 $\mu$m. Thereafter, the glass substrate was heated on a hot plate at 110°C for 10 minutes to dry the films, resulting in CNT assembly films A to F. The surface resistivity of the CNT assembly films A to F thus obtained was measured using Loresta GX II (trade name), which is a resistivity meter manufactured by Nittoseiko Analytech Co., Ltd. The surface resistivity was measured at five different locations on the CNT assembly film, and their average value was defined as the surface resistivity of the CNT assembly. Also, based on the surface resistivity of the CNT assembly, the conductivity of the CNT assembly was evaluated according to the evaluation criteria described below.

The results are shown in Table 1 and Table 2. If the evaluation result was "A" or "B", the conductivity was considered to be excellent. An evaluation result of "A" was considered to be most preferable.

- Evaluation criteria -

A: The surface resistivity of the CNT assembly is less than $1.00 \times 10^2$ Q/sq.
B: The surface resistivity of the CNT assembly is in the range of $1.00 \times 10^2$ Q/sq or more and less than $3.00 \times 10^2$ Q/sq.
C: The surface resistivity of the CNT assembly is in the range of $3.00 \times 10^2$ Q/sq or more and less than $1.00 \times 10^5$ Ω/sq.
D: The surface resistivity of the CNT assembly is $1.00 \times 10^5$ Ω/sq or more.

6. Peak intensity ratio G1/D1 in Raman spectrum

The Raman spectrum of the CNTs contained in the CNT assembly was measured.

The CNT assembly was fixed to the sample stage, and the Raman spectrum was obtained using RAMAN-11 (trade name), which is a Raman spectrometer manufactured by Nanophoton, under the measurement conditions described below.

<Measurement conditions>

Excitation laser wavelength: 532 nm
Grating: 600 grooves/mm
Objective lens: 20x, numerical aperture (N.A.) 0.45
Wavenumber range: 110 cm$^{-1}$ to 2650 cm$^{-1}$

The maximum value of scattering intensity at a Raman shift of 1550 cm$^{-1}$ to 1600 cm$^{-1}$ was defined as the peak intensity G1 of the G band in the Raman spectrum, and the maximum value of scattering intensity at a Raman shift of 1300 cm$^{-1}$ to 1400 cm$^{-1}$ was defined as the peak intensity D1 of the D band in the Raman spectrum, and from these values, the peak intensity ratio G1/D1, which is the ratio of the peak intensity G1 of the G band to the peak intensity D1 of the D band in the Raman spectrum, was calculated.

The results are shown in Table 3.

7. BET specific surface area

The BET specific surface area of the CNTs contained in the CNT assembly was measured.

The BET specific surface area of the CNTs was determined by a gas adsorption method using nitrogen gas in accordance with JIS Z 8830:2013. Specifically, it was determined by the following method.

First, the CNT assembly was packed into a sample tube, and a pretreatment was performed on the CNT assembly by vacuum degassing the inside of the sample tube at 300°C for 3 hours using BELPREP-vac II (trade name), which is a pretreatment apparatus manufactured by MicrotracBEL Corp.

The pretreated CNT assembly was used as a measurement sample, and the amount of nitrogen adsorption of the CNT assembly was measured under the measurement conditions described below using BELSORP-mini II (trade name), which is a specific surface area measurement apparatus manufactured by MicrotracBEL Corp., to obtain an adsorption-desorption isotherm. From the obtained adsorption-desorption isotherm, the BET specific surface area was determined under the analysis conditions described below.

The results are shown in Table 3.

<Measurement and analysis conditions>

Measurement method: Constant volume method
Adsorption temperature: 77 K
Adsorbate: Nitrogen
Saturation vapor pressure: Measured value
Equilibrium waiting time: 500 sec
Specific surface area: BET method (BET-Plot)

[Table 1]

| | Median diameter [nm] | Rate of change in transmittance [%/hour] | Conductivity | |
| --- | --- | --- | --- | --- |
| | | | Surface resistivity [Ω/sq] | Evaluation |
| Example 1 | 108.3 | 0.0744 | $7.71 \times 10^1$ | A |
| Example 2 | 354.2 | 0.123 | $1.64 \times 10^2$ | B |
| Example 3 | 389.0 | 0.128 | $1.64 \times 10^2$ | B |
| Comparative Example 1 | 76.8 | 0.0278 | $4.59 \times 10^2$ | C |
| Comparative Example 2 | 276.3 | 37.9 | $1.06 \times 10^7$ | D |
| Comparative Example 3 | 78.5 | 0.0689 | $7.03 \times 10^3$ | C |

As shown in Table 1, the MWCNT assembly 1 of Example 1, the MWCNT assembly 2 of Example 2, and the MWCNT assembly 3 of Example 3, which comprise MWCNTs having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass, were confirmed to have excellent conductivity.

In contrast, the SWCNT assembly 1 of Comparative Example 1, the MWCNT assembly 4 of Comparative Example 2, and the MWCNT assembly 5 of Comparative Example 3, which comprise CNTs that do not satisfy at least one of the above conditions that the median diameter is 80 nm or more and the rate of change in transmittance is 0.3%/hour or less, were confirmed to have inferior conductivity compared to the Examples.

[Table 2]

|  | Scattering intensity ratio | | Conductivity | |
| --- | --- | --- | --- | --- |
|  | S1/S2 | S3/S4 | Surface resistivity [$\Omega$/sq] | Evaluation |
| Example 1 | 98.1 | 8.29 | $7.71 \times 10^1$ | A |
| Example 2 | 91.1 | 8.24 | $1.64 \times 10^2$ | B |
| Example 3 | 92.8 | 9.99 | $1.64 \times 10^2$ | B |
| Comparative Example 1 | 88.0 | 15.2 | $4.59 \times 10^2$ | C |
| Comparative Example 2 | 58.6 | 58.7 | $1.06 \times 10^7$ | D |
| Comparative Example 3 | 43.0 | 25.1 | $7.03 \times 10^3$ | C |

As shown in Table 2, the MWCNT assembly 1 of Example 1, the MWCNT assembly 2 of Example 2, and the MWCNT assembly 3 of Example 3, which comprise MWCNTs having a scattering intensity ratio S1/S2 of 90 or more, which is the ratio of the scattering intensity S1 at a scattering vector magnitude $q = 0.2$ nm$^{-1}$ to the scattering intensity S2 at a scattering vector magnitude $q = 0.8$ nm$^{-1}$ in a scattering profile obtained by a small-angle X-ray scattering method when formed into an aqueous dispersion liquid having a concentration of 0.2% by mass, were confirmed to have excellent conductivity. In addition, the MWCNT assembly 1 of Example 1, the MWCNT assembly 2 of Example 2, and the MWCNT assembly 3 of Example 3, which comprise MWCNTs having a scattering intensity ratio S3/S4 of 10 or less, which is the ratio of the scattering intensity S3 at a scattering vector magnitude $q = 0.02$ nm$^{-1}$ to the scattering intensity S4 at a scattering vector magnitude $q = 0.08$ nm$^{-1}$ in a scattering profile obtained by a small-angle X-ray scattering method when formed into an aqueous dispersion liquid having a concentration of 0.2% by mass, were confirmed to have excellent conductivity.

In contrast, the SWCNT assembly 1 of Comparative Example 1, the MWCNT assembly 4 of Comparative Example 2, and the MWCNT assembly 5 of Comparative Example 3, which comprise CNTs that do not satisfy the above condition that the scattering intensity ratio S1/S2 is 90 or more, were confirmed to have inferior conductivity compared to the Examples. In addition, the SWCNT assembly 1 of Comparative Example 1, the MWCNT assembly 4 of Comparative Example 2, and the MWCNT assembly 5 of Comparative Example 3, which comprise CNTs that do not satisfy the above condition that the scattering intensity ratio S3/S4 is 10 or less, were confirmed to have inferior conductivity compared to the Examples.

[Table 3]

|  | G1/D1 | BET specific surface area [m$^2$/g] |
| --- | --- | --- |
| Example 1 | 2.00 | 208 |
| Example 2 | 8.23 | 178 |
| Example 3 | 4.26 | 136 |
| Comparative Example 1 | 56.9 | 446 |
| Comparative Example 2 | 11.3 | 22.6 |
| Comparative Example 3 | 0.889 | 203 |

From the results of measurement of the maximum length of MWCNTs by SEM imaging, the results of conductivity evaluation shown in Tables 1 and 2, and the results shown in Table 3, it became clear that the MWCNT assemblies comprising MWCNTs having a maximum length of 1000 $\mu$m to 30000 $\mu$m (so-called ULMWCNTs), wherein the peak intensity ratio G1/D1, which is the ratio of the peak intensity G1 of the G band to the peak intensity D1 of the D band in a Raman spectrum of the MWCNTs, is more than 0.9 and 15 or less, and the MWCNTs have a BET specific surface area of 50 $m^2/g$ to 400 $m^2/g$, have excellent conductivity.

In addition, it became clear that the MWCNT assemblies comprising MWCNTs having a maximum length of more than 1600 μm and 30000 μm or less (so-called specific ULMWCNTs), wherein the peak intensity ratio G1/D1, which is the ratio of the peak intensity G1 of the G band to the peak intensity D1 of the D band in a Raman spectrum of the MWCNTs, is 10 or less, and the MWCNTs have a BET specific surface area of 200 $m^2/g$ to 300 $m^2/g$, also have excellent conductivity.

**Claims**

1. A multi-walled carbon nanotube assembly comprising multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass.

2. A multi-walled carbon nanotube assembly comprising multi-walled carbon nanotubes having a scattering intensity ratio S1/S2 of 90 or more, which is a ratio of a scattering intensity S1 at a scattering vector magnitude q = 0.2 $nm^{-1}$ to a scattering intensity S2 at a scattering vector magnitude q = 0.8 $nm^{-1}$ in a scattering profile obtained by a small-angle X-ray scattering method when formed into an aqueous dispersion liquid having a concentration of 0.2% by mass.

3. A multi-walled carbon nanotube assembly comprising multi-walled carbon nanotubes having a scattering intensity ratio S3/S4 of 10 or less, which is a ratio of a scattering intensity S3 at a scattering vector magnitude q = 0.02 $nm^{-1}$ to a scattering intensity S4 at a scattering vector magnitude q = 0.08 $nm^{-1}$ in a scattering profile obtained by a small-angle X-ray scattering method when formed into an aqueous dispersion liquid having a concentration of 0.2% by mass.

4. A multi-walled carbon nanotube assembly comprising multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass, and having a scattering intensity ratio S1/S2 of 90 or more, which is a ratio of a scattering intensity S1 at a scattering vector magnitude q = 0.2 $nm^{-1}$ to a scattering intensity S2 at a scattering vector magnitude q = 0.8 $nm^{-1}$ in a scattering profile obtained by a small-angle X-ray scattering method when formed into an aqueous dispersion liquid having a concentration of 0.2% by mass.

5. A multi-walled carbon nanotube assembly comprising multi-walled carbon nanotubes having a median diameter of 80 nm or more in a volume-based particle size distribution obtained by a centrifugal sedimentation method when formed into an aqueous dispersion liquid having a concentration of 0.004% by mass, and having a rate of change in transmittance of 0.3%/hour or less as measured by a centrifugal sedimentation method when formed into an aqueous dispersion liquid having a concentration of 0.2% by mass, and having a scattering intensity ratio S3/S4 of 10 or less, which is a ratio of a scattering intensity S3 at a scattering vector magnitude q = 0.02 $nm^{-1}$ to a scattering intensity S4 at a scattering vector magnitude q = 0.08 $nm^{-1}$ in a scattering profile obtained by a small-angle X-ray scattering method when formed into an aqueous dispersion liquid having a concentration of 0.2% by mass.

6. A multi-walled carbon nanotube assembly comprising multi-walled carbon nanotubes having a scattering intensity ratio S1/S2 of 90 or more, which is a ratio of a scattering intensity S1 at a scattering vector magnitude q = 0.2 $nm^{-1}$ to a scattering intensity S2 at a scattering vector magnitude q = 0.8 $nm^{-1}$ in a scattering profile obtained by a small-angle X-ray scattering method, and having a scattering intensity ratio S3/S4 of 10 or less, which is a ratio of a scattering intensity S3 at a scattering vector magnitude q = 0.02 $nm^{-1}$ to a scattering intensity S4 at a scattering vector magnitude q = 0.08 $nm^{-1}$ in the scattering profile, when formed into an aqueous dispersion liquid having a concentration of 0.2% by mass.

7. The multi-walled carbon nanotube assembly according to any one of claims 1 to 6, wherein a maximum length of the multi-walled carbon nanotubes is 1000 μm to 30000 μm.

8. The multi-walled carbon nanotube assembly according to any one of claims 1 to 6, which is a conductive auxiliary agent.

9.  A multi-walled carbon nanotube dispersion liquid comprising the multi-walled carbon nanotube assembly according to any one of claims 1 to 6, and a dispersion medium.

10. A conductive material comprising the multi-walled carbon nanotube assembly according to any one of claims 1 to 6.

11. An electrode comprising an electrode active material and the conductive material according to claim 10.

12. A secondary battery comprising the electrode according to claim 11.

13. A composition comprising the multi-walled carbon nanotube assembly according to any one of claims 1 to 6, and at least one selected from the group consisting of resin, ceramic, and concrete.

14. A planar assembly comprising the multi-walled carbon nanotube assembly according to any one of claims 1 to 6.

15. A filter comprising the planar assembly according to claim 14.

16. An electromagnetic wave shielding comprising the planar assembly according to claim 14.

17. A pellicle for extreme ultraviolet rays comprising the planar assembly according to claim 14.

## Fig. 1A

S4800 1.0kV x500 SE(M)    100um

## Fig. 1B

S4800 1.0kV x500 SE(M)    100um

Fig. 1C

S4800 1.0kV x500 SE(U)                                            100um

Fig. 2

# INTERNATIONAL SEARCH REPORT

| International application No. |
| --- |
| **PCT/JP2024/021496** |

## A. CLASSIFICATION OF SUBJECT MATTER

*C01B 32/158*(2017.01)i; *B01J 27/043*(2006.01)i; *C01B 32/174*(2017.01)i; *H01B 1/04*(2006.01)i; *H01M 4/13*(2010.01)i; *H01M 4/62*(2006.01)i

FI: C01B32/158; H01M4/62 Z; H01B1/04; B01J27/043 M; C01B32/174; H01M4/13

According to International Patent Classification (IPC) or to both national classification and IPC

## B. FIELDS SEARCHED

Minimum documentation searched (classification system followed by classification symbols)

C01B32/158; B01J27/043; C01B32/174; H01B1/04; H01M4/13; H01M4/62

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
| --- | --- | --- |
| X | JP 2018-505121 A (Q-FLO LIMITED) 22 February 2018 (2018-02-22) claim 1, paragraphs [0065]-[0068] | 1-17 |
| A | JP 2015-048263 A (TEIJIN LIMITED) 16 March 2015 (2015-03-16) examples 1-1 - 1-12 | 1-17 |

☐ Further documents are listed in the continuation of Box C.  ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **05 July 2024** | **23 July 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/021496**

| Patent document cited in search report | | | Publication date (day/month/year) | Patent family member(s) | | | Publication date (day/month/year) |
|---|---|---|---|---|---|---|---|
| JP | 2018-505121 | A | 22 February 2018 | US | 2017/0327378 | A1 | |
| | | | | claim 1, example 1 | | | |
| | | | | WO | 2016/087857 | A1 | |
| | | | | claim 1, example 1 | | | |
| | | | | CN | 107207261 | A | |
| | | | | ES | 2716085 | T | |
| | | | | PL | 3227231 | T | |
| JP | 2015-048263 | A | 16 March 2015 | (Family: none) | | | |

Form PCT/ISA/210 (patent family annex) (July 2022)

**REFERENCES CITED IN THE DESCRIPTION**

**Patent documents cited in the description**

- JP 2020180028 A

- JP 2016102047 A

**Non-patent literature cited in the description**

- **KOHJI TASHIRO**. Structural Science of Crystalline Polymers. *Springer*, 2022